(19) Europäisches Patentamt
European Patent Office
Office européen des brevets

(11) EP 2 091 097 A2

(12) **EUROPEAN PATENT APPLICATION**

(43) Date of publication:
**19.08.2009 Bulletin 2009/34**

(51) Int Cl.:
***H01L 51/54*** *(2006.01)*

(21) Application number: **09001464.8**

(22) Date of filing: **03.02.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **13.02.2008 JP 2008032467**

(71) Applicant: **Semiconductor Energy Laboratory Co, Ltd.**
**Atsugi-shi, Kanagawa-ken 243-0036 (JP)**

(72) Inventors:
- **Seo, Satoshi**
**Kanagawa-ken 243-0036 (JP)**
- **Suzuki, Tsunenori**
**Kanagawa-ken 243-0036 (JP)**

(74) Representative: **Grünecker, Kinkeldey, Stockmair & Schwanhäusser Anwaltssozietät**
**Leopoldstrasse 4**
**80802 München (DE)**

(54) **Light-emitting element, light-emitting device, and electronic device**

(57) A light-emitting element including a light-emitting layer (111) and a control layer (121) between a first electrode (102) and a second electrode (104) is provided. The control layer includes a first organic compound and a second organic compound. The amount of the included first organic compound is larger than the amount of the included second organic compound. The second organic compound has the property of trapping carriers that have the same polarity as carriers transported by the first organic compound. The concentration and carrier-trapping property of the second organic compound included in the control layer satisfy certain conditions.

FIG. 1

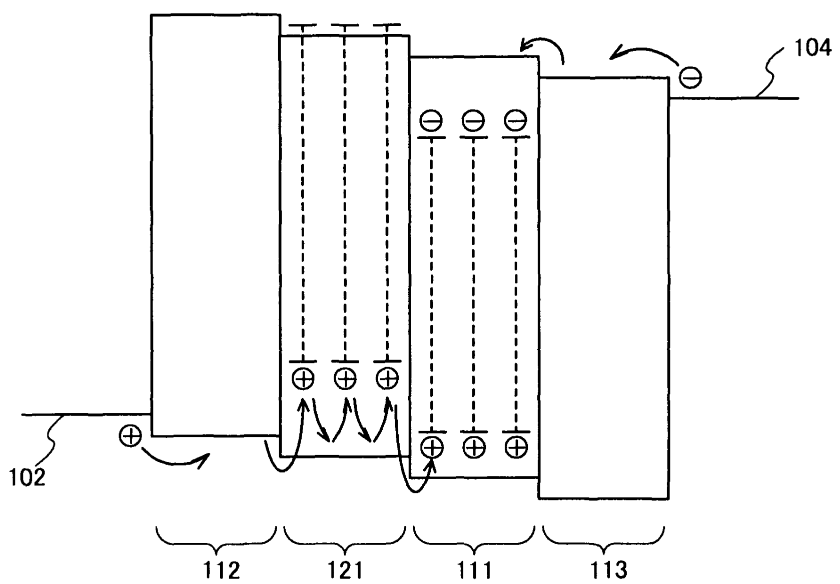


EP 2 091 097 A2

## Description

### BACKGROUND OF THE INVENTION

#### 1. Field of the Invention

The present invention relates to light-emitting elements that employ electroluminescence. Further, the present invention relates to light-emitting devices and electronic devices having such light-emitting elements.

#### 2. Description of the Related Art

In recent years, research and development of light-emitting elements using electroluminescence have been extensively conducted. In the basic structure of such a light-emitting element, a substance having a light-emitting property is interposed between a pair of electrodes. By applying a voltage to this element, light emission can be obtained from the substance having a light-emitting property.

Since such a light-emitting element is a self-luminous type, it has advantages over a liquid crystal display in that visibility of a pixel is higher and that no backlight is needed. Therefore, such a light-emitting element is thought to be suitable as a flat panel display element. Further, such a light-emitting element also has advantages in that the element can be fabricated to be thin and lightweight and that response speed is very high.

Further, since such a light-emitting element can be formed to have a film shape, surface light emission can be easily obtained by forming a large-area element. This is difficult to realize with point sources typified by a filament lamp and an LED or with linear sources typified by a fluorescent light. Therefore, such a light-emitting element also has a high utility value as a surface light source that can be applied to a lighting apparatus or the like.

Light-emitting elements using electroluminescence are broadly classified according to whether they use an organic compound or an inorganic compound as a substance having a light-emitting property.

When an organic compound is used as a substance having a light-emitting property, by application of a voltage to a light-emitting element, electrons and holes are injected into a layer containing the organic compound having a light-emitting property from a pair of electrodes, whereby a current flows. Then, the carriers (i.e., electrons and holes) recombine to place the organic compound having a light-emitting property into an excited state. The organic compound having a light-emitting property returns to a ground state from the excited state, thereby emitting light. Thus, a light-emitting element with such a mechanism is referred to as a current-excitation light-emitting element.

Note that an excited state generated by an organic compound can be of two types: a singlet excited state and a triplet excited state, and luminescence from the singlet excited state is referred to as fluorescence, and luminescence from the triplet excited state is referred to as phosphorescence.

In an attempt to improve the performance of such a light-emitting element, there are many problems depending on a material, and in order to solve these problems, improvement of element structure, development of a material, and the like have been carried out.

For example, in Reference 1 (T Tsutsui, et. al. Japanese Journal of Applied Physics, Vol. 38, L1502-L1504, 1999), by providing a hole-blocking layer, a light-emitting element using a phosphorescent material efficiently emits light.

### SUMMARY OF THE INVENTION

However, as described in Reference 1, a hole-blocking layer does not have durability, and a light-emitting element has very short lifetime. Thus, development of a light-emitting element with long lifetime has been desired. In particular, if commercialization is considered, prolonging the lifetime is an important issue, and development of light-emitting elements with much longer lifetime is desired.

In view of the foregoing problems, the present invention provides a light-emitting element having long lifetime. Further, the present invention provides a light-emitting device and an electronic device having long lifetime.

As a result of diligent studies, the present inventors have found that a light-emitting element with long lifetime can be obtained by providing a control layer for controlling carrier transport. Specifically, the present inventors have also found that when the concentration and carrier-trapping property of an organic compound included in the control layer satisfy a certain conditions, a light-emitting element having long lifetime can be obtained.

Accordingly, an aspect of the present invention is a light-emitting element including a light-emitting layer and a control layer between a first electrode and a second electrode. The control layer includes a first organic compound and a second organic compound. The amount of the included first organic compound is larger than the amount of the included second organic compound, the first organic compound is an organic compound having a hole-transporting property. The highest occupied molecular orbital level (HOMO level) of the second organic compound is higher than the highest occupied molecular orbital level (HOMO level) of the first organic compound. The value of the parameter $X$

obtained by an equation (1) ranges from $1 \times 10^{-8}$ to $1 \times 10^{-2}$, inclusive.

$$X = \frac{1}{L}\left\{\exp\left(-\frac{\Delta E}{kT}\right)\right\}^{\sqrt[3]{C}} \quad \cdots (1)$$

In the equation, $\Delta E$ is an energy difference [eV] between the HOMO level of the first organic compound and the HOMO level of the second organic compound, $C$ is the molar fraction [dimensionless term] of the second organic compound, $L$ is the thickness [nm] of the control layer, $k$ is the Boltzmann constant (= $8.61 \times 10^{-5}$ [$eV \cdot K^{-1}$]), and $T$ is a temperature (= 300 [K]).

In the above aspect, the value of $X$ obtained by the equation (1) preferably ranges from $1 \times 10^{-5}$ to $1 \times 10^{-3}$, inclusive.

In the above aspect, the thickness $L$ of the control layer preferably ranges from 5 nm to 20 nm, inclusive.

Further, in the above aspect, the mobility of the first organic compound preferably ranges from $10^{-6}$ [$cm^2/Vs$] to $10^{-2}$ [$cm^2/Vs$], inclusive, more preferably from $10^{-5}$ [$cm^2/Vs$] to $10^{-3}$ [$cm^2/Vs$], inclusive.

Further, in the above aspect, the energy difference $\Delta E$ between the HOMO level of the first organic compound and the HOMO level of the second organic compound preferably ranges from 0.2 [eV] to 0.6 [eV], inclusive.

Further, in the above aspect, the light-emitting layer preferably has a hole-transporting property. Specifically, the organic compound, the amount of which is the largest of those of all the organic compounds included in the light-emitting layer, preferably has a hole-transporting property. For example, when the light-emitting layer includes a third organic compound and a fourth organic compound and the amount of the third organic compound is larger than the amount of the fourth organic compound, the third organic compound preferably has a hole-transporting property.

In the above aspect, preferably, the control layer and the light-emitting layer are in contact with each other.

Moreover, the present invention includes a light-emitting device having the above-described light-emitting element. Thus, an aspect of the present invention is a light-emitting device that has the above-described light-emitting element and a control circuit configured to control light emission of the light-emitting element.

The term "light-emitting device" in the present specification includes an image display device, a light-emitting device, or a light source (including a lighting apparatus). Further, the following are all included in the "light-emitting device": a module in which a connector, for example, a flexible printed circuit (FPC), a tape automated bonding (TAB) tape, or a tape carrier package (TCP) is attached to a panel provided with a light-emitting element; a module provided with a printed wiring board at the end of the TAB tape or the TCP; and a module in which an integrated circuit (IC) is directly mounted to a light-emitting element by chip on glass (COG) method.

Further, an electronic device in which the light-emitting element of the present invention is used for a display portion is also included in the scope of the invention. Thus, an electronic device of the present invention includes a display portion, in which the display portion includes the above-described light-emitting element and a control circuit configured to control light emission of the light-emitting element.

In the light-emitting element of the present invention, a layer for controlling carrier transport is provided; accordingly, a light-emitting element with long lifetime can be obtained.

Further, a light-emitting element of the present invention is applied to a light-emitting device and an electronic device, whereby the light-emitting device and the electronic device can have longer lifetime.

BRIEF DESCRIPTION OF THE DRAWINGS

FIG 1 illustrates a light-emitting element according to an aspect of the present invention.
FIGS. 2A and 2B each illustrate a light-emitting element according to an aspect of the present invention.
FIGS. 3A and 3B each illustrate a light-emitting element according to an aspect of the present invention.
FIGS. 4A to 4C each illustrate a light-emitting element according to an aspect of the present invention.
FIG 5 illustrates a light-emitting element according to an aspect of the present invention.
FIGS. 6A and 6B illustrate a light-emitting device according to an aspect of the present invention.
FIGS. 7A and 7B illustrate a light-emitting device according to an aspect of the present invention.
FIGS. 8A to 8D each illustrate an electronic device according to an aspect of the present invention.

FIGS. 9A to 9C illustrate an electronic device according to an aspect of the present invention.
FIG 10 illustrates an electronic device according to an aspect of the present invention.
FIG 11 illustrates an electronic device according to an aspect of the present invention.
FIG 12 illustrates a lighting apparatus according to an aspect of the present invention.
FIG 13 illustrates a lighting apparatus according to an aspect of the present invention.
FIG 14 illustrates a lighting apparatus according to an aspect of the present invention.
FIG 15 illustrates a light-emitting element fabricated in Examples.
FIG 16 shows the oxidation reaction characteristic of NPB.
FIG 17 shows the oxidation reaction characteristic of BPAPQ.
FIG 18 shows the oxidation reaction characteristic of 1'-TNATA.
FIG 19 shows the oxidation reaction characteristic of PCzPCA1.
FIGS. 20A and 20B show emission spectra of light-emitting elements fabricated in Example 2.
FIG 21 shows the results of continuous lighting tests of the light-emitting elements fabricated in Example 2.
FIG 22 shows the results of continuous lighting tests of light-emitting elements fabricated in Example 3.
FIG 23 shows the results of continuous lighting tests of light-emitting elements fabricated in Example 4.
FIG 24 is a graph showing a parameter *X*.
FIG 25 is a graph showing the parameter *X*.
FIG 26 is a graph showing the parameter *X*.
FIG 27 is a graph showing the parameter *X*.

DETAILED DESCRIPTION OF THE INVENTION

Hereinafter, embodiment modes of the present invention will be described using the accompanying drawings. Note that the present invention is not limited to the description below, and the modes and details of the present invention can be easily modified in various ways by those skilled in the art without departing from the spirit and scope of the present invention. Therefore, the present invention should not be construed as being limited to the description of the embodiment modes and the examples below Note that in the description of the present invention below, the same reference numerals may be used to denote the same components among the different drawings in some cases.

(Embodiment Mode 1)

A light-emitting element of the present invention includes a light-emitting layer and a control layer for controlling carrier transport between a pair of electrodes. The control layer includes a first organic compound and a second organic compound, and the amount of the included first organic compound is larger than the amount of the included second organic compound. The second organic compound has the property of trapping carriers that have the same polarity as carriers transported by the first organic compound.

In this embodiment mode, the case is described in detail, in which the first organic compound has a hole-transporting property, while the second organic compound has a hole-trapping property. That is, a light-emitting element is described, in which the light-emitting layer and the control layer are provided between the first electrode serving as an anode and the second electrode serving as a cathode, the control layer includes the first organic compound and the second organic compound, the amount of the included first organic compound is larger than the amount of the included second organic compound, the first organic compound is an organic compound having a hole-transporting property, and the highest occupied molecular orbital level (HOMO level) of the second organic compound is higher than the highest occupied molecular orbital level (HOMO level) of the first organic compound.

Note that in this specification, "having low HOMO level or low LUMO level" means having low energy level, and "having high HOMO level or high LUMO level" means having high energy level. For example, it can be said that a substance A having a HOMO level of -5.5 eV has lower HOMO level by 0.3 eV than a substance B having a HOMO level of -5.2 eV and has higher HOMO level by 0.2 eV than a substance C having a HOMO level of -5.7 eV.

FIG 1 illustrates an example of a band diagram of a light-emitting element of the present invention. The light-emitting element of the present invention includes a light-emitting layer 111 and a control layer 121 between a first electrode 102 and a second electrode 104. In FIG 1, a hole-transporting layer 112 is provided between the first electrode 102 and the control layer 121, and an electron-transporting layer 113 is provided between the second electrode 104 and the light-emitting layer 111.

By application of a voltage to the light-emitting element as illustrated in FIG 1, electrons injected from the second electrode are injected into the light-emitting layer through the electron-transporting layer. On the other hand, holes injected from the first electrode are injected into the control layer through the hole-transporting layer. Although the transport velocity of the holes injected into the control layer is reduced due to the hole-trapping property of the second organic compound, lastly, the holes are injected into the light-emitting layer and recombined with electrons, whereby

light is emitted.

In a conventional light-emitting element in which no control layer is provided, without a reduction in transport velocity due to trapping, holes are injected into the light-emitting layer. Accordingly, when the light-emitting layer has a hole-transporting property, holes can easily reach the vicinity of the interface between the electron-transporting layer and the light-emitting layer. Thus, a carrier recombination region (a light-emitting region) is formed in the vicinity of the interface between the electron-transporting layer and the light-emitting layer. In that case, there is a possibility that the holes may reach the electron-transporting layer and make is deteriorate. In addition, as the electron-transporting layer deteriorates and the number of holes that have reached the electron-transporting layer increases over time, the recombination probability in the light-emitting layer decreases over time. This indicates a reduction in the lifetime of the light-emitting element (luminance decay over time).

On the contrary, in the light-emitting element of the present invention, as described above, the transport velocity of holes injected into the control layer is reduced, whereby hole injection to the light-emitting layer is controlled. As a result, the recombination region (light-emitting region), which tends to be formed in the vicinity of the interface between the electron-transporting layer and the light-emitting layer in a conventional light-emitting element, spreads entirely inside the light-emitting layer. Specifically, the recombination region is formed from the inside of the light-emitting layer to the vicinity of the interface between the light-emitting layer and the control layer. Therefore, there is a low possibility that holes may reach the electron-transporting layer and make it deteriorate.

Further, in the present invention, it is important that, instead of simply using a substance having low hole mobility, a second organic compound having the function of trapping holes be added to the first organic compound having a hole-transporting property in the control layer. With such a structure, it becomes possible not only to control hole injection into the light-emitting layer but also to suppress a change in the controlled amount of hole injection over time. Accordingly, in the light-emitting element of the present invention, a phenomenon in which carrier balance deteriorates over time to reduce the recombination probability can be prevented; this leads to improvement of element lifetime (suppression of the luminance decay over time).

Here, the combination of the first organic compound and the second organic compound in the control layer and the concentration of the second organic compound are important. This can be described as below

For example, when a combination having a low hole-trapping property (i.e., a combination in which the HOMO level of the second organic compound is slightly higher than the HOMO level of the first organic compound) is employed for the control layer, unless the concentration of the second organic compound is increased to some extent, the transport velocity of holes in the control layer cannot be reduced, resulting in a state as in a conventional light-emitting element; thus, the effect of prolonging lifetime cannot be obtained. In contrast, when a combination having a high hole-trapping property (i.e., a combination in which the HOMO level of the second organic compound is much higher than the HOMO level of the first organic compound) is employed, if the concentration of the second organic compound is increased too much, the transport velocity of holes in the control layer is reduced too much, and the recombination region is formed inside the control layer. In this case, recombination in the control layer adversely affects lifetime.

In other words, in intuitive understanding, the largest effect of prolonging lifetime can be obtained by setting the concentration of the second organic compound to be relatively high for the combination having a low hole trapping property, or by setting the concentration of the second organic compound to be relatively low for the combination having a high hole trapping property. However, this is merely intuitive understanding, and an optimum value of the concentration varies depending on the combination of materials (i.e., depth at which holes are trapped) and is difficult to estimate.

Here, the present inventors have found that a certain rule is present for an optimum structure of the control layer. In other words, when a parameter $X$ obtained by the equation (1) below, which is determined depending on $\Delta E$ as a depth at which holes are trapped (an energy difference between the HOMO level of the first organic compound and the HOMO level of the second organic compound), $C$ as the concentration of the second organic compound, and $L$ as the thickness of the control layer, is in a certain range, the effect of prolonging lifetime can be obtained.

$$X = \frac{1}{L}\left\{\exp\left(-\frac{\Delta E}{kT}\right)\right\}^{\sqrt[3]{C}} \quad \cdots (1)$$

In this equation, $\Delta E$ is an energy difference [eV] between the HOMO level of the first organic compound and the HOMO level of the second organic compound, $C$ is the molar fraction [dimensionless term] of the second organic compound, $L$ is the thickness [nm] of the control layer, $k$ is the Boltzmann constant (= $8.61 \times 10^{-5}$ [$eV \cdot K^{-1}$]), and $T$ is a

temperature (= 300 [K]).

This equation is obtained from a theory as described below.

First, it is assumed that in the light-emitting element of the present invention, hopping of a hole occurs *n* times to transport the hole through the control layer. In other words, it is assumed that by hopping between *n* molecules, a hole is transported through the control layer. At this time, the expected value $E_n$ of the probability that a hole is trapped during the period when hopping occurs *n* times is represented by the equation:

$$E_n = np$$

where *p* is the probability of the existence of a trap for a hole in the control layer (i.e., the probability of the existence of the second organic compound). For example, if the probability of the existence *p* is 0.1 (10 %) and hopping occurs ten times ($n$ = 10), *np* is calculated as follows:

$$np = 10 \times 0.1 = 1$$

This indicates that, statistically, a hole is trapped about once during the period when it is transported through the control layer. That is, the expected value ($E_n = np$) is the statistical average value of the number of times in which a hole is trapped during the period when hopping occurs n times.

Next, *K* is assumed as the probability that, after being captured by a trap, a hole can escape from the trap. Here, since the above expected value ($E_n = np$) is the number of (average value of) times in which a hole is trapped, a final probability $K_{all}$ that hopping of a hole occurs *n* times to transport the hole through the control layer is the $E_n$-th power of *K*. In other words, an equation (2) below is obtained. This equation indicates that, for example, if $E_n = np = 2$, a hole is trapped in the control layer twice in average and thus $K_{all}$ is $K^2$. Note that when there is no trap ($p$ = 0), $K_{all}$ is I and thus is normalized.

$$K_{all} = K^{np} \qquad \cdots (2)$$

Further, since $K_{all}$ is the probability that hopping of a hole occurs *n* times to transport the hole through the control layer, an average probability $K_{ave}$ that a hole can be transported through the control layer per hopping is an *n*-th power root of $K_{all}$. Accordingly, from the equation (2), an equation (3) below is obtained.

$$K_{ave} = \sqrt[n]{K_{all}} = K^p \qquad \cdots (3)$$

Here, what kinds of physical quantities the average probability $K_{ave}$ influences is considered. In accordance with quantum theory, if $K_{ave}$ is 0.5, one hole of two injected holes cannot go forward (whether a hole can be transported or not). However, as can be seen from the equation (2), the above consideration is based on the expected value, and thus average behavior should be considered. For example, if the distance between molecules is $L_0$ and $K_{ave}$ is 0.5, the transport distance of one hole of two injected holes is $L_0$ and the transport distance of the other hole is 0, whereby the average value of the transport distance becomes as follows:

$$(L_0 + 0)/2 = 0.5L_0.$$

In other words, $K_{ave}$ is directly proportional to the transport distance of a hole, i.e., the drift velocity of a hole. Therefore, when *v* is the drift velocity of holes in the control layer and $v_0$ is the drift velocity of holes in the first organic compound,

an equation (4) below can be postulated.

$$v = v_0 K^p \quad \cdots (4)$$

Next, what kinds of physical quantities *K* and *p* in the equation (4) are represented with is considered. First, *p* is the probability of the existence of a trap for a hole (i.e., probability of the existence of the second organic compound), and thus is simply the concentration of the second organic compound. Note that in the light-emitting element as disclosed in the present invention, hole transport is controlled more by drift in an electric field direction than by diffusion, and thus hole transport should be considered using a model only in the thickness direction of the element, i.e., one dimensional model. Accordingly, when *C* is the concentration (molar fraction) of the second organic compound, *C* is the molar fraction per unit volume (i.e., three dimensions), whereby an equation (5) below is obtained.

$$p = \sqrt[3]{C} \quad \cdots (5)$$

On the other hand, since *K* is the probability that a hole can escape from a trap, kinetically, *K* shows the Boltzmann distribution. Thus, an equation (6) below can be obtained.

$$K = \exp\left(-\frac{\Delta E}{kT}\right) \quad \cdots (6)$$

In this equation, $\Delta E$ is an energy difference [eV] between the HOMO level of the first organic compound and the HOMO level of the second organic compound, *k* is the Boltzmann constant (= $8.61 \times 10^{-5}$ [$eV \cdot K^{-1}$]), and *T* is a temperature [K].

By assigning the equation (5) and the equation (6) to the equation (4), an equation (7) below which is one of the important features of the present invention can be obtained.

$$v = v_0 \left\{ \exp\left(-\frac{\Delta E}{kT}\right) \right\}^{\sqrt[3]{C}} \quad \cdots (7)$$

In this equation, $\Delta E$ is an energy difference [eV] between the HOMO level of the first organic compound and the HOMO level of the second organic compound, *C* is the molar fraction [dimensionless term] of the second organic compound, *k* is the Boltzmann constant (= $8.61 \times 10^{-5}$ [$eV \cdot K^{-1}$]), and *T* is a temperature.

Here, when *L* [nm] (the unit is nm in consideration of the thickness scale of the light-emitting element of the present invention, for convenience) is the thickness of the control layer and *t* [s] is the time it takes a hole to be transported through the control layer, the following equation is obtained:

$$t\,[\mathrm{s}] = L\,[\mathrm{nm}] / v\,[\mathrm{nm/s}].$$

In addition, the reciprocal of *t* [s] is represented by the following equation:

$$x\,[\mathrm{s}^{-1}] = 1 / t\,[\mathrm{s}],$$

where *x* can be seen as the velocity constant of a hole transported through the control layer (*x* is the proportional constant of the number of holes transported through the control layer). The velocity constant *x* is represented by an equation (8) below using the equation (7).

$$x = 1/t = v/L = \frac{v_0}{L}\left\{\exp\left(-\frac{\Delta E}{kT}\right)\right\}^{\sqrt[3]{C}} \quad \cdots (8)$$

In this equation, $\Delta E$ is an energy difference [eV] between the HOMO level of the first organic compound and the HOMO level of the second organic compound, *C* is the molar fraction [dimensionless term] of the second organic compound, *L* is the thickness [nm] of the control layer, *k* is the Boltzmann constant (= $8.61 \times 10^{-5}$ [$eV \cdot K^{-1}$]), and *T* is a temperature.

As described above, the effect of prolonging lifetime due to the control layer cannot be obtained if an excessive number of holes are transported through the control layer or if an excessive number of holes are trapped in the control layer. That is, the effect of prolonging lifetime cannot be obtained unless the velocity constant *x* is kept in an appropriated range.

Thus, the present inventors have experimentally found that the effect of prolonging lifetime can be actually obtained when the velocity constant *x* is in a certain range.

Note that $v_0$ is a value that can vary depending on what kind of organic compound is used as the first organic compound, and further is a value under influences of mobility and electric field intensity (drift velocity = mobility × electric field intensity). However, in the equation (8), the exponential term is thought to be dominant, and therefore $v_0$ is normalized ($v_0$ = 1) in the experiment. In addition, since the experiment is conducted at room temperature, *T* is 300 [K].

Thus, if $v_0$ is 1 and *T* is 300 [K], the velocity constant *x* is the parameter *X* (the equation (1) below), and a relationship between the parameter *X* and the lifetime of the element is experimentally verified. As a result, it is found that the effect of prolonging lifetime can be obtained when the parameter *X* ranges from $1 \times 10^{-8}$ to $1 \times 10^{-2}$, preferably from $1 \times 10^{-5}$ to $1 \times 10^{-3}$.

$$X = \frac{1}{L}\left\{\exp\left(-\frac{\Delta E}{kT}\right)\right\}^{\sqrt[3]{C}} \quad \cdots (1)$$

In this equation, $\Delta E$ is an energy difference [eV] between the HOMO level of the first organic compound and the HOMO level of the second organic compound, *C* is the molar fraction [dimensionless term] of the second organic compound, *L* is the thickness [nm] of the control layer, *k* is the Boltzmann constant (= $8.61 \times 10^{-5}$ [$eV \cdot K^{-1}$]), and *T* is a temperature (= 300 [K]).

Note that in the above equation (1), the drift velocity $v_0$ of the first organic compound is normalized, but actually, if the drift velocity varies by several orders of magnitude, errors in parameter *X* can be caused. The drift velocity is a product of mobility and electric field intensity, and the electric field intensity does not vary by orders of magnitude in the

luminance region for actual use. However, if the mobility varies by several orders of magnitude, the drift velocity also varies by several orders of magnitude, and thus errors in parameter *X* can be caused.

Therefore, in consideration of the report that the mobility of NPB which can be used for the first organic compound is about $10^{-4}$ [$cm^2$/Vs] and the fact that the parameter *X* varies by about two orders of magnitude, the mobility of the first organic compound preferably varies within the range of about ± two orders of magnitude from $10^{-4}$ [$cm^2$/Vs] corresponding to the mobility of NPB. Therefore, the mobility of the first organic compound preferably ranges from $10^{-6}$ to $10^{-2}$ [$cm^2$/Vs], more preferably from $10^{-5}$ to $10^{-3}$ [$cm^2$/Vs].

In addition, the thickness *L* of the control layer influences the parameter *X*. The thickness *L* of the control layer preferably ranges from 1 to 100 [nm], more preferably from 5 to 20 [nm].

Further, when the energy difference $\Delta E$ between the HOMO level of the first organic compound and the HOMO level of the second organic compound is large, an trapping effect is large even if the concentration of the second organic compound is low, and therefore the concentration of the second organic compound in the control layer is needed to be accurately controlled. On the other hand, when the energy difference $\Delta E$ is small, the trapping effect of the second organic compound is small, and therefore the concentration of the second organic compound can be easily controlled. Thus, the energy difference $\Delta E$ between the HOMO level of the first organic compound and the HOMO level of the second organic compound preferably ranges from 0.2 to 0.6 [eV] in fabrication of a light-emitting element.

As a substance that can be used for the above-described control layer, a wide variety of organic compounds can be used. Here, it is important that an appropriate material be selected and the concentration thereof be adjusted so that the parameter *X* obtained by the equation (1) can range from $1 \times 10^{-8}$ to $1 \times 10^{-2}$.

For example, as the first organic compound, an organic compound having a hole-transporting property, i.e., a substance in which the hole-transporting property is higher than the electron-transporting property can be used. Specifically, it is possible to use any of aromatic amine compounds such as 4,4'-bis[*N*-(1-naphthyl)-*N*-phenylamino]biphenyl (abbreviation: NPB or α-NPD), 4,4'-bis[*N*-(9,9-dimethylfluoren-2-yl)-*N*-phenylamino]biphenyl (abbreviation: DFLDPBi), *N*,*N'*-bis(spiro-9,9'-bifluoren-2-yl)-*N*,*N'*-diphenylbenzidine (abbreviation BSPB), 4,4'-bis[*N*-(3-methylphenyl)-*N*-phenylamino]biphenyl] (abbreviation: TPD), 1,3,5-tris[*N*,*N*-di(*m*-tolyl)amino]benzene (abbreviation: *m*-MTDAB), 4,4',4"-tris(*N*-carbazolyl)triphenylamine (abbreviation: TCTA), *N*,*N*-diphenyl-9-[4-(10-phenyl-9-antryl)phenyl]-9*H*-carbazol-3-amine (abbreviation: CzA1PA), 9-phenyl-9'-[4-(10-phenyl-9-anthryl)phenyl]-3,3'-bi(9*H*-carbazole) (abbreviation: PCCPA), 4-(10-phenyl-9-anthryl)triphenylamine (abbreviation: DPhPA), 4-(9*H*-carbazol-9-yl)-4'-(10-phenyl-9-anthryl)triphenylamine (abbreviation: YGAPA), *N*,9-diphenyl-*N*-[4-(10-phenyl-9-anthryl)phenyl]-9*H*-carbazol-3-amine (abbreviation: PCAPA), *N*,9-diphenyl-*N*-{4-[4-(10-phenyl-9-anthryl)phenyl]phenyl}-9*H*-carbazol-3-amine (abbreviation: PCAPBA), *N*,9-diphenyl-*N*-(9,10-diphenyl-2-anthryl)-9*H*-carbazol-3-amine (abbreviation: 2PCAPA), 6,12-dimethoxy-5,11-diphenylchrysene, *N,N,N',N',N'',N'',N''',N'''*octaphenyldibenzo[*g,p*]chrysene-2,7,10,15-tetraamine (abbreviation: DBC1), 4,4'-(quinoxaline-2,3-diyl)bis(*N,N*-diphenylaniline) (abbreviation: TPAQn), *N,N'*-(quinoxaline-2,3-diyldi-4,1-phenylene)bis(*N*-phenyl-1,1'-biphenyl-4-amine) (abbreviation: BPAPQ), *N,N'*-(quinoxaHne-2,3-diyldi-4,1-phenylene)bis[bis(1,1'-biphenyl-4-yl)amine] (abbreviation: BBAPQ), 4,4'-(quinoxaline-2,3-diyl)bis{*N*-[4-(9*H*-carbazol-9-yl)phenyl]-*N*-phenylaniline} (abbreviation: YGAPQ), *N,N'*-(quinoxaline-2,3-diyldi-4,1-phenylene)bis(*N*,9-diphenyl-9*H*-carbazol-3-amine) (abbreviation: PCAPQ), 4-(9*H*-carbazol-9-yl)-4'-(3-phenylquinoxalin-2-yl)triphenylamine (abbreviation: YGA1PQ), 4-(9*H*-carbazol-9-yl)-4'-(3-phenylquinoxalin-2-yl)triphenylamine (abbreviation: PCAlPQ), or *N,N,N'*-triphenyl-*N'*-[4-(3-phenylquinoxalin-2-yl)phenyl]1,4-phenylenediamine (abbreviation: DPAlPQ), or condensed aromatic compounds such as 9,10-diphenylanthracene (abbreviation: DPAnth). Note that a compound in which a quinoxaline skeleton and aromatic amine are combined, such as TPAQn, BPAPQ, BBAPQ, YGAPQ, PCAPQ, YGA1PQ, PCA1PQ, or DPA1PQ, has a relatively high hole-transporting property while having a bipolar property, and therefore is preferably used as the first organic compound. Alternatively, any of high molecular compounds such as poly(*N*-vinylcarbazole) (abbreviation: PVK), poly(4-vinyltriphenylamine) (abbreviation: PVTPA), poly[*N*-(4-{*N'*-[4-(4-diphenylamino)phenyl]phenyl-*N'*-phenylamino}phenyl)methacryla mide] (abbreviation: PTPDMA), or poly[*N,N'*-bis(4-butylphenyl)-*N,N'*-bis(phenyl)benzidine] (abbreviation: Poly-TPD) can be used. Further, as described above, the HOMO level of the second organic compound is preferably higher than that of the first organic compound. Therefore, the first organic compound may be selected as appropriate so as to satisfy the above conditions according to the second organic compound. For example, as described later in Examples, when 4,4',4''-tris[*N*-(1-naphthyl)-*N*-phenylamino]triphenylamine (abbreviation: 1'-TNATA), 3-[*N*-(9-phenylcarbazol-3-yl)-*N*-phenylamino]-9-phenylcarbazole (abbreviation: PCzPCAl), or the like is used for the second organic compound, NPB or BPAPQ is used for the first organic compound, whereby the above conditions are satisfied.

Further, the second organic compound preferably has a HOMO level higher than the HOMO level of the first organic compound. Therefore, the second organic compound may be selected as appropriate according to what kind of organic compound is used as the first organic compound so as to satisfy the above conditions.

Thus, a substance having high HOMO level is preferable for the second organic compound. As examples, in addition to 1'-TNATA and PCzPCAl which are described above, there are 4,4',4"-tris(*N*,*N*-diphenylamino)triphenylamine (abbreviation: TDATA), 4,4',4"-tris[*N*-(3-methylphenyl)-*N*-phenylamino]triphenylamine (abbreviation: MTDATA), 1,3,5-tris[*N*-(4-diphenylaminophenyl)-*N*-phenylamino]benzene (abbreviation: DPA3B), *N*,*N'*-bis(4-methylphenyl)-*N*,*N*-diphenyl-*p*-phenylenediamine (abbreviation: DTDPPA), 4,4'-bis[*N*-(4-diphenylaminophenyl)-*N*-phenylamino]biphenyl (abbreviation: DPAB), 4,4'-bis(*N*-{4-[*N*'-(3-methylphenyl)-*N*'-phenylamino]phenyl}-*N*-phenylamino)biphenyl (abbreviation: DNTPD), and the like. Further, a phosphorescent material such as tris(2-phenylpyridinato-*N,C*$^{2'}$)iridium(III) (abbreviation: $Ir(ppy)_3$) can also be used. Note that each of the above-described compounds is a compound having particularly high HOMO level among compounds that are used for light-emitting elements. Thus, when any of the above compounds is added to the above-described first organic compound, an excellent hole-trapping property is exhibited.

As described above, the light-emitting element described in this embodiment mode includes the layer for controlling carrier transport. Since the layer for controlling carrier transport includes two or more kinds of substances, carrier balance can be precisely controlled by control of the combination, mixture ratio, thickness, etc. of the substances.

Further, since the control of the combination, mixture ratio, thickness, etc. of the substances enables the carrier balance to be controlled, the carrier balance can be controlled more easily than in a conventional case. That is, even if the physical properties of the substance are not changed, the carrier transport can be controlled with the mixture ratio of the substances, the thickness of the layer, etc. Accordingly, a wider choice of materials and more flexible design can be achieved.

The carrier transport is controlled using the organic compound, the amount of which is the smallest of those of the two or more kinds of substances included in the control layer for controlling carrier transport. That is, the carrier transport can be controlled with a component the amount of which is the smallest of those of components included in the control layer for controlling carrier transport. Accordingly, the light-emitting element hardly deteriorates over time and can have long lifetime. In other words, the carrier balance in the light-emitting element hardly changes as compared with the case where the carrier balance is controlled with one substance. For example, when the carrier transport is controlled with a layer including one substance, the carrier balance of the whole layer is changed by a partial change in morphology, partial crystallization, or the like. Therefore, the layer for controlling carrier transport in that case easily deteriorates over time. However, as described in this embodiment mode, the carrier transport is controlled with a component, the amount of which is the smallest of those of the components included in the control layer for controlling carrier transport, whereby a change in morphology or effect of crystallization, aggregation, or the like is reduced, and then the change over time is hardly caused. Thus, it is possible to obtain a light-emitting element with long lifetime in which a reduction in carrier balance over time, which may result in a reduction in light emission efficiency over time, is hardly caused.

(Embodiment Mode 2)

One mode of a light-emitting element of the present invention is hereinafter described using FIGS. 2A and 2B, FIGS. 3A and 3B, and FIGS. 4A to 4C. The light-emitting element of the present invention includes a control layer for controlling carrier transport, as described in Embodiment Mode 1.

The light-emitting element of the present invention includes a plurality of layers between a pair of electrodes. The plurality of layers are a combination of layers including a substance having a high carrier-injecting property and/or a substance having a high carrier-transporting property, which are stacked so that a light-emitting region can be formed in a region away from the electrodes, that is, so that carriers recombine in an area away from the electrodes.

In this embodiment mode, the light-emitting element includes a first electrode 102, a second electrode 104, and an EL layer 103 provided between the first electrode 102 and the second electrode 104. Note that in this embodiment mode, the first electrode 102 serves as an anode and the second electrode 104 serves as a cathode. That is, when a voltage is applied to the first electrode 102 and the second electrode 104 such that the potential of the first electrode 102 is higher than that of the second electrode 104, light emission can be obtained. Such a case will be described below.

A substrate 101 is used as a support of the light-emitting element. The substrate 101 can be formed using, for example, glass, plastic, or the like. Alternatively, the substrate 101 may be formed using any other material as long as the material can serve as a support in the fabrication process of the light-emitting element.

The first electrode 102 is preferably formed using a metal, an alloy, an electrically conductive compound, a mixture thereof, or the like each having a high work function (specifically, a work function of 4.0 eV or more is preferable). Specifically, indium oxide-tin oxide (ITO: indium tin oxide), indium oxide-tin oxide containing silicon or silicon oxide, indium oxide-zinc oxide (IZO), indium oxide containing tungsten oxide and zinc oxide (IWZO), and the like can be used, for example. Such conductive metal oxide films are generally formed by sputtering, but may also be formed by an inkjet method, a spin coating method, or the like by application of a sol-gel method or the like. For example, an indium oxide-zinc oxide (IZO) film can be formed using a target in which I wt% to 20 wt% of zinc oxide is added to indium oxide by a sputtering method. A film of indium oxide containing tungsten oxide and zinc oxide (IWZO) can be formed using a target in which 0.5 wt% to 5 wt% tungsten oxide and 0.1 wt% to 1 wt% zinc oxide are added to indium oxide by a sputtering method. Besides, there are gold (Au), platinum (Pt), nickel (Ni), tungsten (W), chromium (Cr), molybdenum (Mo), iron (Fe), cobalt (Co), copper (Cu), palladium (Pd), titanium (Ti), nitride of a metal material (e.g., titanium nitride), and the like.

When a layer containing a composite material described below is used as a layer in contact with the first

electrode, any of a variety of metals, alloys, electrically conductive compounds, mixtures thereof, or the like can be used for the first electrode regardless of the work functions. For example, aluminum (Al), silver (Ag), an alloy including aluminum (e.g., AlSi), or the like can be used. Besides, an any of elements belonging to Group 1 and 2 of the periodic table, which have a low work function, i.e., alkali metals such a lithium (Li) and cesium (Cs) and alkaline earth metals such as magnesium (Mg), calcium (Ca), and strontium (Sr), alloys thereof (e.g., MgAg and AlLi), rare earth metals such as europium (Eu) and ytterbium (Yb), alloys thereof, or the like can also be used. A film of an alkali metal, an alkaline earth metal, or an alloy thereof can be formed by a vacuum evaporation method. In addition, an alloy including an alkali metal or an alkaline earth metal can be formed by a sputtering method. Further, a film of silver paste or the like can be formed by an inkjet method.

The second electrode 104 can be formed using a metal, an alloy, an electrically conductive compound, or a mixture thereof, having a low work function (specifically, a work function of 3.8 eV or less is preferable). As specific examples of such cathode materials, there are elements belonging to Group I and 2 of the periodic table, that is, alkali metals such as lithium (Li) and cesium (Cs), alkaline earth metals such as magnesium (Mg), calcium (Ca), and strontium (Sr), alloys including the element belonging to Group 1 and 2 (e.g., MgAg, AlLi), rare-earth metals such as europium (Eu) and ytterbium (Yb), alloys thereof, and the like. A film of an alkali metal, an alkaline earth metal, or an alloy including these can be formed by a vacuum evaporation method. In addition, an alloy including an alkali metal or an alkaline earth metal can be formed by a sputtering method. Further, a film of silver paste or the like can be formed by an inkjet method.

By provision of a hole-injecting layer 115 described later, as a layer in contact with the second electrode 104, the second electrode 104 can be formed using any of various conductive materials such as Al, Ag, ITO, and indium oxide-tin oxide containing silicon or silicon oxide, regardless of the work functions. Films of these conductive materials can be formed by a sputtering method, an inkjet method, a spin coating method, or the like.

The EL layer 103 is provided between the first electrode 102 and the second electrode 104. The EL layer includes a light-emitting layer and a control layer for controlling carrier transport. In this embodiment mode, a light-emitting element that includes a control layer 121 for controlling hole transport as a layer for controlling carrier transport is described.

The control layer 121 for controlling hole transport is provided between the light-emitting layer 111 and the first electrode 102 serving as an anode. The structure described in Embodiment Mode 1 can be applied to the control layer 121 for controlling hole transport.

The light-emitting layer 111 is a layer including a substance having a high light-emitting property, and any of a variety of materials can be used for the light-emitting layer 111. As the substance having a high light-emitting property, for example, a fluorescent compound which emits fluorescence or a phosphorescent compound which emits phosphorescence can be used.

Examples of phosphorescent compounds that can be used for the light-emitting layer are given below Examples of materials for blue light emission are as follows: bis[2-(4',6'-difluorophenyl)pyridinato-*N*,$C^{2'}$]iridium(III) tetrakis(1-pyrazolyl)borate (abbreviation: FIr6), bis[2-(4',6'-difluorophenyl)pyridinato-*N*,$C^{2'}$]iridium(ITI) picolinate (abbreviation: FIrpic), bis[2-(3',5'bistrifluoromethylphenyl)pyridinato-*N*,$C^{2'}$]iridium(III) picolinate (abbreviation: $Ir(CF_3ppy)_2(pic)$), bis[2-(4',6'-difluorophenyl)pyridinato-*N*,$C^{2'}$]iridium(III) acetylacetonate (abbreviation: FIracac), and the like. Further, examples of materials for green light emission are as follows: tris(2-phenylpyridinato-*N*,$C^{2'}$)iridium(III) (abbreviation: $Ir(ppy)_3$), bis(2-phenylpyridinato-*N*,$C^{2'}$)iridium(III) acetylacetonate (abbreviation: $Ir(ppy)_2(acac)$), bis(1,2-diphenyl-1*H*-benzimidazolato) iridium(III) acetylacetonate (abbreviation: $Ir(pbi)_2(acac)$), bis(benzo[*h*]quinolinato)iridium(III) acetylacetonate (abbreviation: $Ir(bzq)_2(acac)$), and the like. Further, examples of materials for yellow light emission are as follows: bis(2,4-diphenyl-1,3-oxazolato-*N*,$C^{2'}$)iridium(III) acetylacetonate (abbreviation: $Ir(dpo)_2(acac)$), bis[2-(4'-perfluorophenylphenyl)pyridinato]iridium(III) acetyl acetonate (abbreviation: $Ir(p\text{-}PF\text{-}ph)_2(acac)$), bis(2-phenylbenzothiazolato-*N*,$C^{2'}$)iridium(III) acetylacetonate (abbreviation: $Ir(bt)_2(acac)$), and the like. Further, examples of materials for orange light emission are as follows: tris(2-phenylquinolinato-*N*,$C^{2'}$)iridium(III) (abbreviation: $Ir(pq)_3$), bis(2-phenylquinolinato-*N*,$C^{2'}$)iridium(III) acetylacetonate (abbreviation: $Ir(pq)_2(acac)$), and the like. Further, examples of materials for red light emission are organometallic complexes such as bis[2-(2'-benzo[4,5-α]thienyl)pyridinato-*N*,$C^{3'}$]iridium(III) acetylacetonate (abbreviation: Ir $(btp)_2(acac)$), bis(1-phenylisoquinolinato-*N*,$C^{2'}$)iridium(III) acetylacetonate (abbreviation: $Ir(piq)_2(acac)$), (acetylacetonato)bis[2,3-bis(4-fluorophenyl)quinoxalinato]iridium(III) (abbreviation: $Ir(Fdpq)_2(acac)$), and 2,3,7,8,12,13,17,18-octaethyl-21*H*,23*H*-porphyrin platinum(II) (abbreviation: PtOEP). In addition, since a rare earth metal complex such as tris (acetylacetonato)(monophenanthroline)terbium(III) (abbreviation: $Tb(acac)_3(Phen)$), tris(1,3-diphenyl-1,3-propanedionato)(monophenanthroline)europium(III) (abbreviation: $Eu(DBM)_3(Phen)$), or tris[1-(2-thenoyl)-3,3,3-trifluoroacetonato] (monophenanthroline)europium(III) (abbreviation: $Eu(TTA)_3(Phen)$) exhibits light emission (hole transition between different multiplets) from a rare earth metal ion, such a rare earth metal complex can be used as a phosphorescent compound.

Examples of fluorescent compounds that can be used for the light-emitting layer are given below Examples of materials for blue light emission are as follows: *N,N'*-bis[4-(9*H*-carbazol-9-yl)phenyl]-*N,N'*-diphenylstilbene-4,4'-diamine (abbreviation: YGA2S), 4-(9*H*-carbazol-9-yl)-4'-(10-phenyl-9-anthryl)triphenylamine (abbreviation: YGAPA), and the like. Further, examples of materials for green light emission are as follows: *N*-(9,10-diphenyl-2-anthryl)-*N*,9-diphenyl-9*H*-carbazol-3-amine (abbreviation: 2PCAPA), *N*-[9,10-bis(1,1'-biphenyl-2-yl)-2-anthryl]-*N*,9-diphenyl-9*H*-carbazol-3-amine (abbreviation: 2PCABPhA), *N*-(9,10-diphenyl-2-anthryl)-*N,N',N'*-triphenyl-1,4-phenylenediamine (abbreviation: 2DPAPA), *N*-[9,10-bis(1,1'-biphenyl-2-yl)-2-anthryl]-*N,N',N'*-triphenyl-1,4-phenylenediamine (abbreviation: 2DPABPhA), 9,10-bis(1,1'-biphenyl-2-yl)-N-[4-(9H-carbazol-9-yl)phenyl]-*N*-phenylanthracen-2-amin e (abbreviation: 2YGABPhA), *N,N*,9-triphenylanthracen-9-amine (abbreviation: DPhAPhA), and the like. Further, examples of materials for yellow light emission are as follows: rubrene, 5,12-bis(1,1'-biphenyl-4-yl)-6,11-diphenyltetracene (abbreviation: BPT), and the like. Further, examples of materials for red light emission are as follows: *N,N,N',N'*-tetrakis(4-methylphenyl) tetracene-5,11-diamine (abbreviation: p-mPhTD), 7,13-diphenyl-*N,N,N',N'*-tetrakis(4-methylphenyl)acenaphtho[ 1,2-a] fluoranthene-3,10-d iamine (abbreviation: p-mPhAFD), and the like.

Note that the light-emitting layer may have a structure in which the above substance having a high light-emitting property (a guest material) is dispersed in another substance (a host material). As the substance in which the substance having a high light-emitting property is dispersed, a variety of kinds of substances can be used, and it is preferable to use a substance that has a lowest unoccupied molecular orbital (LUMO) level higher than that of a substance having a high light-emitting property and has a highest occupied molecular orbital (HOMO) level lower than that of the substance having a high light-emitting property.

In particular, for the host material, a compound having a hole-transporting property is preferable because of the principle as described in Embodiment Mode 1. For example, it is possible to use any of aromatic amine compounds such as 4,4'-bis[*N*-(1-naphthyl)-*N*-phenylamino]biphenyl (abbreviation: NPB or α-NPD), 4,4'-bis[*N*-(9,9-dimethylfluoren-2-yl)-*N*-phenylamino]biphenyl (abbreviation: DFLDPBi), *N,N'*-bis(spiro-9,9'-bifluoren-2-yl)-*N,N'*-diphenylbenzidine (abbreviation BSPB), 4,4'-bis[*N*-(3-methylphenyl)-*N*-phenylamino]biphenyl] (abbreviation: TPD), 1,3,5-tris[*N,N*-di(*m*-tolyl) amino]benzene (abbreviation: *m*-MTDAB), 4,4',4"-tris(N-carbazolyl)triphenylamine (abbreviation: TCTA), *N,N*-diphenyl-9-[4-(10-phenyl-9-antryl)phenyl]-9*H*-carbazol-3-amine (abbreviation: CzAlPA), 9-phenyl-9'-[4-(10-phenyl-9-anthryl)phenyl]-3,3'-bi(9*H*-carbazole) (abbreviation: PCCPA), 4-(10-phenyl-9-anthryl)triphenylamine (abbreviation: DPhPA), 4-(9*H*-carbazol-9-yl)-4'-(10-phenyl-9-anthryl)triphenylamine (abbreviation: YGAPA), *N*,9-diphenyl-*N*-[4-(10-phenyl-9-anthryl)phenyl]-9*H*-carbazol-3-amine (abbreviation: PCAPA), *N*,9-diphenyl-*N*-{4-[4-(10-phenyl-9-anthryl)phenyl]phenyl}-9*H*-carbazol-3-amine (abbreviation: PCAPBA), *N*,9-diphenyl-*N*-(9,10-diphenyl-2-anthryl)-9*H*-carbazol-3-amine (abbreviation: 2PCAPA), 6,12-dimethoxy-5,11-diphenylchrysene, *N,N,N'N",N",N''',N'''*-octaphenyldibenzo[*g,p*]chrysene-2,7,10,15-tetraamine (abbreviation: DBC1), 4,4'-(quinoxaline-2,3-diyl)bis(*N,N*-diphenylaniline) (abbreviation: TPAQn), *N,N'*(quinoxaline-2,3-diyldi-4,1-phenylene)bis(*N*-phenyl-1,1'-biphenyl-4-amine) (abbreviation: BPAPQ), *N,N'*-(quinoxaline-2,3-diyldi-4,1-phenylene)bis[bis(1,1'-biphenyl-4-yl)amine] (abbreviation: BBAPQ), 4,4'-(quinoxaline-2,3-diyl)bis {*N*-[4-(9*H*-carbazol-9-yl)phenyl]-*N*-phenylaniline} (abbreviation: YGAPQ), *N,N'*-(quinoxaline-2,3-diyldi-4,1-phenylene) bis(N,9-diphenyl-9*H*-carbazol-3-amine) (abbreviation: PCAPQ), 4-(9*H*-carbazol-9-yl)-4'-(3-phenylquinoxalin-2-yl)triphenylamine (abbreviation: YGA1PQ), 4-(9*H*-carbazol-9-yl)-4'-(3-phenylquinoxalin-2-yl)triphenylamine (abbreviation: PCAlPQ), or *N,N,N'*-triphenyl-*N'*-[4-(3-phenylquinoxalin-2-yl)phenyl]1,4-phenylenediamine (abbreviation: DPA1PQ), or condensed aromatic compounds such as 9,10-diphenylanthracene (abbreviation: DPAnth). Note that a compound in which a quinoxaline skeleton and aromatic amine are combined, such as TPAQn, BPAPQ, BBAPQ, YGAPQ, PCAPQ, YGAlPQ, PCAlPQ, or DPAlPQ, has a relatively high hole-transporting property while having a bipolar property, and therefore is preferably used. Alternatively, any of high molecular compounds such as poly(*N*-vinylcarbazole) (abbreviation: PVK), poly(4-vinyltriphenylamine) (abbreviation: PVTPA), poly[*N*-(4-{*N'*-[4-(4-diphenylamino)phenyl]phenyl-*N'*-phenylamino}phenyl)methacryla mide] (abbreviation: PTPDMA), or poly[*N,N'*-bis(4-butylphenyl)-*N,N*-bis(phenyl)benzidine] (abbreviation: Poly-TPD) can be used.

In addition, for example, the following compound having a hole-transporting property is preferable: tris(8-quinolinolato)aluminum(III) (abbreviation: Alq), tris(4-methyl-8-quinolinolato)aluminum(III) (abbreviation: $Almq_3$), bis(10-hydroxybenzo[*h*]quinolinato)beryllium(II) (abbreviation: $BeBq_2$), bis(2-methyl-8-quinolinolato)(4-phenylphenolato)aluminum(III) (abbreviation: BAlq), bis(8-quinolinolato)zinc(II) (abbreviation: Znq), bis[2-(2-benzoxazolyl)phenolato]zinc(II) (abbreviation: ZnPBO), bis[2-(2-benzothiazolyl)phenolato]zinc(II) (abbreviation: ZnBTZ), 2-(4-biphenylyl)-5-(4-*tert*-butylphenyl)-1,3,4-oxadiazole (abbreviation: PBD), 1,3-bis[5-(*p*-*tert*-butylphenyl)-1,3,4-oxadiazol-2-yl]benzene (abbreviation: OXD-7), 3-(4-biphenylyl)-4-phenyl-5-(4-*tert*-butylphenyl)-1,2,4-triazole (abbreviation: TAZ01), 2,2',2''-(1,3,5-benzenetriyl)tris(1-phenyl-1*H*-benzimidazole) (abbreviation: TPBI), bathophenanthroline (abbreviation: BPhen), bathocuproine (abbreviation: BCP), 9-[4-(5-phenyl-1,3,4-oxadiazole-2-yl)phenyl]-9*H*-carbazole (abbreviation: CO11), 9-[4-(10-phenyl-9-anthryl)phenyl]-9*H*-carbazole (abbreviation: CzPA), 3,6-diphenyl-9-[4-(10-phenyl-9-anthryl)phenyl]-9*H*-carbazole (abbreviation: DPCzPA), 9,10-bis(3,5-diphenylphenyl)anthracene (abbreviation: DPPA), 9,10-di(2-naphthyl)anthracene (abbreviation: DNA), 2-*tert*-butyl-9,10-di(2-naphthyl)anthracene (abbreviation: t-BuDNA), 9,9'-bianthryl (abbreviation: BANT), 9,9'-(stilbene-3,3'-diyl)diphenanthrene (abbreviation: DPNS), 9,9'-(stilbene-4,4'-diyl)diphenanthrene (abbreviation: DPNS2), or 3,3',3"-(benzene-1,3,5-triyl)tripyrene (abbreviation: TPB3).

Further, as a substance in which the substance having a light-emitting property is dispersed, a plurality of kinds of substances can be used. For example, in order to suppress crystallization, a substance for suppressing crystallization, such as rubrene may be further added. Furthermore, in order to efficiently transfer energy to the substance having a

light-emitting property, NPB, Alq or the like may be further added.

With a structure in which a substance having a high light-emitting property is dispersed in another substance, crystallization of the light-emitting layer 111 can be suppressed. Further, concentration quenching due to high concentration of the substance having a high light-emitting property can be suppressed.

Note that for the light-emitting layer 111, a high molecular compound can be used. Specifically, examples of materials for blue light emission are as follows: poly(9,9-dioctylfluorene-2,7-diyl) (abbreviation: POF), poly[(9,9-dioctylfluorene-2,7-diyl)-*co*-(2,5-dimethoxybenzene-1,4-diyl)] (abbreviation: PF-DMOP), poly {(9,9-dioctylfluorene-2,7-diyl)-co-[*N,N'*-di-(*p*-butylphenyl)-1,4-diaminobenzene]} (abbreviation: TAB-PFH), and the like. Further, examples of materials for green light emission are as follows: poly(*p*-phenylenevinylene) (abbreviation: PPV), poly[(9,9-dihexylfluorene-2,7-diyl)-*alt-co*-(benzo[2,1,3]thiadiazole-4,7-diyl)] (abbreviation: PFBT), poly[(9,9-dioctyl-2,7-divinylenefluorenylene)-*alt-co*-(2-methoxy-5-(2-ethylhexyloxy)-1 ,4-phenylene)], and the like. Further, examples of materials for orange to red light emission are as follows: poly[2-methoxy-5-(2'-ethylhexoxy)-1,4-phenylenevinylene] (abbreviation: MEH-PPV), poly(3-butylthiophene-2,5-diyl) (abbreviation: R4-PAT), poly {[9,9-dihexyl-2,7-bis(1-cyanovinylene)fluorenylene]-*alt-co*-[2,5-bis(*N,N'*-diphenyl amino)-1,4-phenylene]}, poly{[2-methoxy-5-(2-ethylhexyloxy)-1,4-bis(1-cyanovinylenephenylene)]-*alt-co*-[2,5-bis(*N,N'*-diphenylamino)-1,4-phenylene]} (abbreviation: CN-PPV-DPD), and the like.

As described above, the EL layer 103 described in this embodiment mode includes the light-emitting layer 111 and the control layer 121 for controlling hole transport. There is no particular limitation on the stack structure of the other layers, and a control layer for controlling carrier transport and a light-emitting layer may be combined, as appropriate, with any of layers including a substance having a high electron-transporting property, a substance having a high hole-transporting property, a substance having a high electron-injecting property, a substance having a high hole-injecting property, a bipolar substance (a substance having a high electron-transporting property and a high hole-transporting property), or the like. For example, the structure can be formed by combining a hole-injecting layer, a hole-transporting layer, an electron-transporting layer, an electron-injecting layer, and/or the like, as appropriate. Materials for each of the layers are specifically given below

The hole-injecting layer 114 is a layer including a substance having a high hole-injecting property. As a substance having a high hole-injecting property, molybdenum oxide, vanadium oxide, ruthenium oxide, tungsten oxide, manganese oxide, or the like can be used. Besides, as examples of low molecular organic compounds, there are phthalocyanine-based compounds such as phthalocyanine (abbreviation: $H_2Pc$), copper(II) phthalocyanine (abbreviation: CuPc), and vanadyl phthalocyanine (VOPc), aromatic amine compounds such as 4,4',4''-tris(*N,N*-diphenylamino)triphenylamine (abbreviation: TDATA), 4,4',4''-tris[*N*-(3-methylphenyl)-*N*-phenylamino]triphenylamine (abbreviation: MTDATA), 4,4'-bis[*N*-(4-diphenylaminophenyl)-*N*-phenylamino]biphenyl (abbreviation: DPAB), 4,4'-bis(*N*-{4-[*N'*-(3-methylphenyl)-*N'*-phenylamino]phenyl}-*N*-phenylamino)biphenyl (abbreviation: DNTPD), 1,3,5-tris[*N*-(4-diphenylaminophenyl)-*N*-phenylamino]benzene (abbreviation: DPA3B), 3-[*N*-(9-phenylcarbazol-3-yl)-*N*-phenylamino]-9-phenylcarbazole (abbreviation: PCzPCAl), 3,6-bis[*N*-(9-phenylcarbazol-3-yl)-*N*-phenylamino]-9-phenylcarbazole (abbreviation: PCzPCA2), and 3-[*N*-(1-naphthyl)-*N*-(9-phenylcarbazol-3-yl)amino]-9-phenylcarbazole (abbreviation: PCzPCNl), and the like.

Alternatively, the hole-injecting layer 114 can be formed using a composite material in which an acceptor substance is included in a substance having a high hole-transporting property. Note that, by using a material in which an acceptor substance is included in a substance having a high hole-transporting property, a material used for forming an electrode may be selected regardless of the work functions. In other words, besides a material with a high work function, a material with a low work function may also be used as the first electrode 102. Such composite materials can be formed by co-evaporation of a substance having a high hole-transporting property and an acceptor substance.

Note that in this specification, the term "composite" refers not only to a state in which two kinds of materials are simply mixed, but also to a state in which charges can be given and received between materials by mixture of a plurality of materials.

As the organic compound used for the composite material, any of a variety of compounds such as aromatic amine compounds, carbazole derivatives, aromatic hydrocarbons, or high molecular compounds (oligomers, dendrimers, polymers, etc.) can be used. Note that the organic compound used for the composite material is preferably an organic compound having a high hole-transporting property. Specifically, a substance having a hole mobility of $10^{-6}$ $cm^2/Vs$ or more is preferably used. Further, any other substance may be used as long as it is a substance in which the hole-transporting property is higher than the electron-transporting property. The organic compounds that can be used for the composite material are specifically given below

Examples of the organic compounds that can be used for the composite material are as follows: aromatic amine compounds such as MTDATA, TDATA, DPAB, DNTPD, DPA3B, PCzPCAl, PCzPCA2, PCzPCNl, 4,4'-bis[*N*-(1-naphthyl)-*N*-phenylamino]biphenyl (abbreviation: NPB or α-NPD), and *N,N'*-bis(3-methylphenyl)-*N,N'*-diphenyl-[1,1'-biphenyl]-4,4'-diamine (abbreviation: TPD), carbazole derivatives such as 4,4'-di(*N*-carbazolyl)biphenyl (abbreviation: CBP), 1,3,5-tris[4-(*N*-carbazolyl)phenyl]benzene (abbreviation: TCPB), 9-[4-(10-phenyl-9-anthryl)phenyl]-9*H*-carbazole (abbreviation: CzPA), and 1,4-bis[4-(*N*-carbazolyl)phenyl]-2,3,5,6-tetraphenylbenzene, and aromatic hydrocarbon compounds such as 2-*tert*-butyl-9,10-di(2-naphthyl)anthracene (abbreviation: t-BuDNA), 2-*tert*-butyl-9,10-di(1-naphthyl)anthracene, 9,10-bis(3,5-diphenylphenyl)anthracene (abbreviation: DPPA), 2-*tert*-butyl-9,10-bis(4-phenylphenyl)anthracene (abbreviation: t-BuDBA), 9,10-di(2-naphthyl)anthracene (abbreviation: DNA), 9,10-diphenylanthracene (abbreviation: DPAnth), 2-tert-butylanthracene (abbreviation: t-BuAnth), 9,10-bis(4-methyl-1-naphthyl)anthracene (abbreviation: DMNA), 9,10-bis[2-(1-naphthyl)phenyl]-2-*tert*-butyl-anthracene, 9,10-bis[2-(1-naphthyl)phenyl]anthracene, 2,3,6,7-tetramethyl-9,10-di(1-naphthyl)anthracene, 2,3,6,7-tetramethyl-9, 10-di(2-naphthyl)anthracene, 9,9'-bianthryl, 10,10'-diphenyl-9,9'-bianthryl, 10,10'-bis(2-phenylphenyl)-9,9'-bianthryl, 10,10'-bis[(2,3,4,5,6-pentaphenyl)phenyl]-9,9'-bianthryl, anthracene, tetracene, rubrene, perylene, 2,5,8,11-tetra(*tert*-butyl)peryiene, pentacene, coronene, 4,4'-bis(2,2-diphenylvinyl)biphenyl (abbreviation: DPVBi), and 9,10-bis[4-(2,2-diphenylvinyl)phenyl]anthracene (abbreviation: DPVPA).

Examples of the acceptor substance are as follows: organic compounds such as 7,7,8,8-tetracyano-2,3,5,6-tetrafluoroquinodimethane (abbreviation: $F_4$-TCNQ) and chloranil, and transition metal oxides. Other examples are oxides of metals belonging to Group 4 to Group 8 of the periodic table. Specifically, vanadium oxide, niobium oxide, tantalum oxide, chromium oxide, molybdenum oxide, tungsten oxide, manganese oxide, and rhenium oxide are preferable because of their high electron-accepting properties. Among these, molybdenum oxide is especially preferable because it is stable in air and its hygroscopic property is low so that it can be easily handled.

Alternatively, for the hole-injecting layer 114, any of high molecular compounds (oligomers, dendrimers, polymers, etc.) can be used. Examples of high molecular compounds include poly(*N*-vinylcarbazole) (abbreviation: PVK), poly(4-vinyltriphenylamine) (abbreviation: PVTPA), poly[*N*-(4-{*N'*-[4-(4-diphenylamino)phenyl]phenyl-*N'*-phenylamino}phenyl)methacryla mide] (abbreviation: PTPDMA), and poly[*N,N'*-bis(4-butylphenyl)-*N,N'*-bis(phenyl)benzidine (abbreviation: Poly-TPD). Alternatively, a high molecular compound to which acid is added, such as poly(3,4-ethylenedioxythiophene)/poly(styrenesulfonic acid) (PEDOT/PSS) or polyaniline/poly(styrenesulfonic acid) (PAni/PSS), can be used.

Alternatively, for the hole-injecting layer 114, a composite material formed using any of the above-mentioned high molecular compounds such as PVK, PVTPA, PTPDMA, or Poly-TPD and any of the above-mentioned acceptor substances can be used.

The hole-transporting layer 112 is a layer including a substance having a high hole-transporting property. As a substance having a high hole-transporting property, a low molecular organic compound can be used, and examples thereof include aromatic amine compounds such as NPB (or α-NPD), TPD, 4,4'-bis[*N*-(9,9-dimethylfluoren-2-yl)-*N*-phenylamino]biphenyl (abbreviation: DFLDPBi), and 4,4'-bis[*N*-(spiro-9,9'-bifluoren-2-yl)-*N*-phenylamino]biphenyl (abbreviation: BSPB). The substances mentioned here are mainly substances having a hole mobility of $10^{-6}$ $cm^2/Vs$ or more. However, any other substance may also be used as long as it is a substance in which the hole-transporting property is higher than the electron-transporting property. Note that the layer including a substance having a high hole-transporting property is not limited to a single layer and may be a stack of two or more layers including any of the above-mentioned substances.

Alternatively, for the hole-transporting layer 112, any of the following high molecular compounds can be used: poly(N-vinylcarbazole) (abbreviation: PVK), poly(4-vinyltriphenylamine) (abbreviation: PVTPA), poly[*N*-(4-{*N'*-[4-(4-diphenylamino)phenyl]phenyl-*N'*-phenylamino}phenyl)methacryla mide] (abbreviation: PTPDMA), and poly[*N,N'*-bis(4-butylphenyl)-*N,N'*-bis(phenyl)benzidine (abbreviation: Poly-TPD).

The electron-transporting layer 113 is a layer including a high electron-transporting property. For example, as a low molecular organic compound, any of metal complexes such as tris(8-quinolinolato)aluminum(III) (abbreviation: Alq), tris(4-methyl-8-quinolinolato)aluminum(III) (abbreviation: $Almq_3$), bis(10-hydroxybenzo[*h*]quinolinato)beryllium(II) (abbreviation: $BeBq_2$), bis(2-methyl-8-quinolinolato)(4-phenylphenolato)aluminum(III) (abbreviation: BAlq), bis(8-quinolinolato)zinc(II) (abbreviation: Znq), bis[2-(2-benzoxazolyl)phenolato]zinc(II) (abbreviation: ZnPBO), and bis[2-(2-benzothiazolyl)phenolato]zinc(II) (abbreviation: ZnBTZ) can be used. Alternatively, other than the metal complexes, any of heterocyclic compounds such as 2-(4-biphenylyl)-5-(4-*tert*-butylphenyl)-1,3,4-oxadiazole (abbreviation: PBD), 1,3-bis [5-(*p*-*tert*-butylphenyl)-1,3,4-oxadiazol-2-yl]benzene (abbreviation: OXD-7), 3-(4-biphenylyl)-4-phenyl-5-(4-*tert*-butylphenyl)-1,2,4-triazole (abbreviation: TAZ01), 2,2',2''-(1,3,5-benzenetriyl)tris(1-phenyl-1*H*-benzimidazole) (abbreviation: TPBI), bathophenanthroline (abbreviation: BPhen), and bathocuproine (abbreviation: BCP) can be used. The substances mentioned here are mainly substances having an electron mobility of $10^{-6}$ $cm^2/Vs$ or more. Note that any other substance may also be used as long as it is a substance in which the electron-transporting property is higher than the hole-transporting property. Note that the electron-transporting layer is not limited to a single layer and may be a stack of two or more layers containing any of the above-mentioned substances.

Alternatively, a high molecular compound can be used for the electron-transporting layer 113. Examples thereof include poly[(9,9-dihexylfluorene-2,7-diyl)-co-(pyridine-3,5-diyl)] (abbreviation: PF-Py), poly[(9,9-dioctylfluorene-2,7-diyl)-co-(2,2'-bipyridine-6,6'-diyl)] (abbreviation: PF-BPy), and the like.

Further, the electron-injecting layer 115 is a layer including a substance having a high electron-injecting property. As the substance having a high electron-injecting property, any of alkali metals, alkaline earth metals, or compounds thereof, such as lithium fluoride (LiF), cesium fluoride (CsF), and calcium fluoride ($CaF_2$) can be used. For example, a layer including a material having an electron-transporting property, which contains an alkali metal, an alkaline earth

metal, or a compound thereof, such as a layer including Alq, which contains magnesium (Mg), can be used. Note that by using a layer including a material having an electron-transporting property, which contains an alkali metal or an alkaline earth metal as the electron-injecting layer, electrons injection from the second electrode 104 is performed efficiently, which is preferable.

Any of a variety of methods can be employed for forming the EL layer 103 regardless of a dry process or a wet process. For example, a vacuum evaporation method, an inkjet method, a spin coating method, or the like may be used. Further, formation methods, which are different for each electrode or each layer, may be used.

For example, the EL layer may be formed using a high molecular compound selected from the above-described materials by a wet method. Alternatively, the EL layer can be formed using a low molecular organic compound by a wet method. Further alternatively, the EL layer may be formed using a low molecular organic compound by a dry method such as vacuum evaporation.

The electrode may be formed by a wet method using sol-gel method, or by a wet method using paste of a metal material. Alternatively, the electrode may be formed by a dry method such as sputtering or vacuum evaporation.

For example, when the light-emitting element of the present invention is applied to a display device and its light-emitting layers are formed separately for each color, each light-emitting layer is preferably formed by a wet process. By forming the light-emitting layers by an inkjet method, the light-emitting layers are easy to form separately for each color even when a large substrate is used.

In the light-emitting element of the present invention having the structure as described above, by application of a voltage, a current flows between the first electrode 102 and the second electrode 104, and holes and electrons recombine in the EL layer 103, whereby light is emitted.

The emitted light is extracted out through one or both of the first electrode 102 and the second electrode 104. Accordingly, one or both of the first electrode 102 and the second electrode 104 is/are an electrode having a light transmitting property. When only the first electrode 102 has a light transmitting property, light emission is extracted from a substrate side through the first electrode 102, as illustrated in FIG 4A. Alternatively, when only the second electrode 104 has a light transmitting property, as illustrated in FIG 4B, light is extracted from the side opposite to the substrate through the second electrode 104. When each of the first electrode 102 and the second electrode 104 has a light-transmitting property, the emitted light is extracted from both the substrate side and the side opposite to the substrate side through the first electrode 102 and the second electrode 104, as illustrated in FIG 4C.

Note that the structure of layers provided between the first electrode 102 and the second electrode 104 are not limited to the above structure. Any structure instead of the above structure can be employed as long as a light-emitting region for recombination of electrons and holes is positioned away from the first electrode 102 and the second electrode 104 so as to prevent quenching due to the proximity of the light-emitting region and a metal and also the layer for controlling carrier transport is provided.

That is, there is no limitation on the stack structure of the layers. The control layer for controlling carrier transport and the light-emitting layer that are described in this embodiment mode are combined with any of layers including a substance having a high electron-transporting property, a substance having a high hole-transporting property, a substance having a high electron-injection property, a substance having a high hole-injecting property, or a substance having a bipolar property (a substance having a high electron-transporting property and a hole-transporting property), as appropriate.

Further, since the control layer for controlling hole transport controls hole transport, it is preferably provided between the light-emitting layer and the electrode functioning as an anode. As illustrated in FIG 2A, the control layer for controlling hole transport is more preferably provided so as to be in contact with the light-emitting layer. By providing the control layer for controlling hole transport so as to be in contact with the light-emitting layer, hole injection into the light-emitting layer can be directly controlled. Therefore, a change in carrier balance in the light-emitting layer over time can be suppressed more efficiently, whereby the lifetime of the element can be more effectively improved. Furthermore, the process can be simplified.

Further, the control layer for controlling hole transport is preferably provided so as to be in contact with the light-emitting layer. In such a case, the first organic compound which is included in the control layer for controlling hole transport and the organic compound, the amount of which is large in the light-emitting layer, may be of the same or different kinds.

Note that as illustrated in FIG 2B, a layer may be formed between the light-emitting layer 111 and the control layer 121 for controlling hole transport. In FIG 2B, a first hole-transporting layer 112A is provided between the control layer 121 for controlling hole transport and the hole-injecting layer 114 for controlling hole transport, and a second hole-transporting layer 112B is provided between the light-emitting layer 111 and the control layer 121 for controlling hole transport.

In addition, as illustrated in FIGS. 3A and 3B, over the substrate 101, the second electrode 104 functioning as a cathode, the EL layer 103, and the first electrode 102 functioning as an anode may be stacked in that order. In FIG 3A, a structure is employed in which the electron-injecting layer 115, the electron-transporting layer 113, the light-emitting

layer 111, the control layer 121 for controlling hole transport, the hole-transporting layer 112, and the hole-injecting layer 114 are stacked in that order over the second electrode 104. In FIG 3B, a structure is employed in which the electron-injecting layer 115, the electron-transporting layer 113, the light-emitting layer 111, the second hole-transporting layer 112B, the control layer 121 for controlling hole transport, the first hole-transporting layer 112A, and the hole-injecting layer 114 are stacked in that order over the second electrode 104.

Note that in this embodiment mode, the light-emitting element is formed over a substrate formed using glass, plastic, or the like. By forming a plurality of such light-emitting elements over a substrate, a passive matrix light-emitting device can be manufactured. Moreover, the light-emitting element may be manufactured over an electrode that is electrically connected to, for example, a thin film transistor (TFT) formed over a substrate formed using glass, plastic, or the like. Thus, an active matrix light-emitting device in which driving of a light-emitting element is controlled by a TFT can be manufactured. Note that there is no limitation on the structure of a TFT, and either a staggered TFT or an inverted staggered TFT may be used. In addition, a driving circuit formed over a TFT substrate may be formed using an n-channel TFT and a p-channel TFT, or may be formed using any one of an n-channel TFT or a p-channel TFT. In addition, there is no limitation on the crystallinity of a semiconductor film used for the TFT. Either an amorphous semiconductor film or a crystalline semiconductor film may be used for the TFT. Further, a single crystalline semiconductor film may be used. The single crystalline semiconductor film can be formed by a Smart Cut (registered trademark) method or the like.

As described above, a feature of the light-emitting element described in this embodiment mode is that the control layer 121 for controlling hole transport is provided. By forming a light-emitting element so that the concentration and carrier-trapping property of the second organic compound included in the control layer can satisfy certain conditions, the light-emitting element with a small amount of deterioration and long lifetime can be obtained.

Note that this embodiment mode can be combined with any of the embodiment modes as appropriate.

(Embodiment Mode 3)

In Embodiment Mode 3, a mode of a light-emitting element in which a plurality of light-emitting units of the present invention are stacked (hereinafter, referred to as a stacked type element) is described with reference to FIG 5. This light-emitting element is a stacked-type element including a plurality of light-emitting units between a first electrode and a second electrode. Each structure of the light-emitting units can be similar to that described in Embodiment Mode 1 or Embodiment Mode 2. In other words, the light-emitting element described in Embodiment Mode 1 or Embodiment Mode 2 is a light-emitting element having one light-emitting unit. In this embodiment mode, a light-emitting element having a plurality of light-emitting units will be described.

In FIG 5, a first light-emitting unit 511, a charge-generating layer 513, and a second light-emitting unit 512 are stacked between a first electrode 501 and a second electrode 502. Materials similar to those in Embodiment Mode 2 can be applied to the first electrode 501 and the second electrode 502. The first light-emitting unit 511 and the second light-emitting unit 512 may have either the same or different structure, which can be similar to that described in Embodiment Mode 2.

The charge-generating layer 513 is a layer that injects electrons into a light-emitting unit on one side and injects holes into a light-emitting unit on the other side when a voltage is applied to the first electrode 501 and the second electrode 502, and may be either a single layer or a stack of plural layers. As a stack structure of plural layers, a structure in which a hole-injecting layer and an electron-injecting layer are stacked is preferable.

As the hole-injecting layer, a semiconductor or an insulator, such as molybdenum oxide, vanadium oxide, rhenium oxide, or ruthenium oxide, can be used. Alternatively, the hole-injecting layer may have a structure in which an acceptor substance is added to a substance having a high hole-transporting property. The layer including a substance having a high hole-transporting property and an acceptor substance is formed using the composite material described in Embodiment Mode 2 and includes, as an acceptor substance, 7,7,8,8-tetracyano-2,3,5,6-tetrafluoroquinodimethane (abbreviation: $F_4$-TCNQ) or metal oxide such as vanadium oxide, molybdenum oxide, or tungsten oxide. As the substance having a high hole-transporting property, any of a variety of compounds such as aromatic amine compounds, carbazole derivatives, aromatic hydrocarbons, or high molecular compounds (oligomers, dendrimers, polymers, etc.) can be used. Note that a substance having a hole mobility of $10^{-6}$ $cm^2/Vs$ or more is preferably employed as the substance having a high hole-transporting property. However, any other substance may also be used as long as it is a substance in which the hole-transporting property is higher than the electron-transporting property. Since the composite material of the substance having a high hole-transporting property and the acceptor substance has an excellent carrier-injecting property and an excellent carrier-transporting property, low-voltage driving and low-current driving can be realized.

As the electron-injecting layer, an insulator or a semiconductor, such as lithium oxide, lithium fluoride, or cesium carbonate, can be used. Alternatively, the electron-injecting layer may have a structure in which a donor substance is added to a substance having a high electron-transporting property. As the donor substance, an alkali metal, an alkaline earth metal, a rare earth metal, a metal belonging to Group 13 of the periodic table, or an oxide or carbonate thereof can be used. Specifically, lithium (Li), cesium (Cs), magnesium (Mg), calcium (Ca), ytterbium (Yb), indium (In), lithium

oxide, cesium carbonate, or the like is preferably used. Alternatively, an organic compound such as tetrathianaphthacene may be used as the donor substance. As the substance having a high electron-transporting property, the materials described in Embodiment Mode 2 can be used. Note that a substance having an electron mobility of $10^{-6}$ $cm^2/Vs$ or more is preferably employed as the substance having a high electron-transporting property. However, any other substance may also be used as long as it is a substance in which the electron-transporting property is higher than the hole-transporting property. Since the composite material of the substance having a high electron-transporting property and the donor substance has an excellent carrier-injecting property and an excellent carrier-transporting property, low-voltage driving and low-current driving can be realized.

Further, for the charge-generating layer 513, the electrode materials described in Embodiment Mode 2 can be used. For example, the charge-generating layer 513 may be formed by combining a layer including a substance having a hole-transporting property and metal oxide with a transparent conductive film. Note that as the charge-generating layer, a layer having a high light-transmitting property is preferably used in terms of light extraction efficiency.

In any case, the charge-generating layer 513 interposed between the first light-emitting unit 511 and the second light-emitting unit 512 may have any structure as long as electrons can be injected into the light-emitting unit on one side and holes can be injected into the light-emitting unit on the other side when a voltage is applied between the first electrode 501 and the second electrode 502. For example, any structure is acceptable for the charge-generating layer 513 as long as the charge-generating layer 513 injects electrons into the first light-emitting unit 511 and holes into the second light-emitting unit 512 when a voltage is applied so that the potential of the first electrode can be higher than that of the second electrode.

In this embodiment mode, the light-emitting element having two light-emitting units is described. However, the present invention can similarly be applied to a light-emitting element in which three or more light-emitting units are stacked. As in the light-emitting element according to this embodiment mode, by arranging a plurality of light-emitting units between a pair of electrodes so that the plurality of light-emitting units can be partitioned by a charge generation layer, light emission in a high luminance region can be achieved with current density kept low; thus, a light-emitting element having long life can be realized. Further, when the light-emitting element is applied to a lighting apparatus, voltage drop due to resistance of the electrode materials can be suppressed; thus, uniform light emission in a large area can be achieved. Furthermore, a light-emitting device capable of low-voltage driving with less power consumption can be realized.

Further, by forming light-emitting units to emit light of different colors from each other, a light-emitting element as a whole can provide light emission of a desired color. For example, by forming a light-emitting element having two light-emitting units such that the emission color of the first light-emitting unit and the emission color of the second light-emitting unit are complementary to each other, the light-emitting element can provide white light emission as a whole. Note that "complementary colors" refer to colors that can produce an achromatic color when mixed. That is, when light emitted from substances that emit light of complementary colors is mixed, white light emission can be obtained. Further, the same can be applied to a light-emitting element having three light-emitting units. For example, the light-emitting element as a whole can provide white light emission when the emission color of the first light-emitting unit is red, the emission color of the second light-emitting unit is green, and the emission color of the third light-emitting unit is blue.

Note that this embodiment mode can be combined with any of the other embodiment modes as appropriate.

(Embodiment Mode 4)

In this embodiment mode, a light-emitting device having a light-emitting element of the present invention will be described.

In this embodiment mode, a light-emitting device having a light-emitting element of the present invention in a pixel portion is described with reference to FIGS. 6A and 6B. Note that FIG 6A is a top view illustrating the light-emitting device and FIG 6B is a cross-sectional view of FIG 6A taken along lines A-A'and B-B'. This light-emitting device includes a driver circuit portion (a source side driver circuit) 601, a pixel portion 602, and a driver circuit portion (a gate side driver circuit) 603, which are indicated by dotted lines, in order to control the light emission of the light-emitting element. Further, reference numeral 604 denotes a sealing substrate and reference numeral 605 denotes a sealing material. Reference numeral 607 denotes a space surrounded by the sealing material 605.

Note that a leading wiring 608 is a wiring for transmitting signals that are input to the source side driver circuit 601 and the gate side driver circuit 603. The leading wiring 608 receives video signals, clock signals, start signals, reset signals, and the like from an flexible printed circuit (FPC) 609 serving as an external input terminal. Note that although only an FPC is illustrated here, this FPC may be provided with a printed wiring board (PWB). The light-emitting device in this specification includes not only a light-emitting device itself but also a light-emitting device to which an FPC or a PWB is attached.

Then, a cross-sectional structure is described using FIG 6B. The driver circuit portions and the pixel portion are provided over an element substrate 610, but only the source side driver circuit 601, which is the driver circuit portion,

and one pixel of the pixel portion 602 are illustrated in FIG 6B.

Note that a CMOS circuit which is a combination of an n-channel TFT 623 and a p-channel TFT 624 is formed in the source side driver circuit 601. The driver circuit may be formed using various types of circuits such as CMOS circuits, PMOS circuits, or NMOS circuits. Further, in this embodiment mode, a driver-integrated type in which a driver circuit is formed over the substrate provided with the pixel portion is described; however, the present invention is not limited to this type, and the driver circuit can be formed outside the substrate.

Further, the pixel portion 602 includes a plurality of pixels each having a switching TFT 611, a current controlling TFT 612, and a first electrode 613 which is electrically connected to a drain of the current controlling TFT 612. Note that an insulator 614 is formed to cover the end portion of the first electrode 613. Here, a positive photosensitive acrylic resin film is used to form the insulator 614.

Further, in order to improve the coverage, the insulator 614 is provided such that either an upper end portion or a lower end portion of the insulator 614 has a curved surface with a curvature. For example, when positive photosensitive acrylic is used as a material for the insulator 614, it is preferable that only an upper end portion of the insulator 614 have a curved surface with a radius of curvature (0.2 μm to 3 μm). Alternatively, the insulator 614 can be formed using either a negative type that becomes insoluble in an etchant by light irradiation or a positive type that becomes soluble in an etchant by light irradiation.

An EL layer 616 and a second electrode 617 are formed over the first electrode 613. Here, a variety of metals, alloys, electrically conductive compounds, or mixtures thereof can be used for a material of the first electrode 613. If the first electrode is used as an anode, it is preferable that the first electrode be formed using, among such materials, any of metals, alloys, electrically conductive compounds, or mixtures thereof having a high work function (preferably, a work function of 4.0 eV or more) among such materials. For example, the first electrode 613 can be formed using a single-layer film such as an indium oxide-tin oxide film containing silicon, an indium oxide-zinc oxide film, a titanium nitride film, a chromium film, a tungsten film, a Zn film, a Pt film, or the like; a stack of a titanium nitride film and a film containing aluminum as the main component; or a three-layer structure of a titanium nitride film, a film containing aluminum as the main component, and a titanium nitride film. Note that with a stack structure, the first electrode 613 has low resistance as a wiring, forms a favorable ohmic contact, and can serve as an anode.

Further, the EL layer 616 is formed by various methods such as an evaporation method using an evaporation mask, an inkjet method, a spin coating method, or the like. The EL layer 616 includes the control layer for controlling carrier transport described in Embodiment Modes 1 and 2. Any of low molecular compounds and high molecular compounds (the category includes oligomers, dendrimers, polymers, etc.) may be used as a material for the EL layer 616. The material for the EL layer is not limited to an organic compound and may be an inorganic compound.

Further, as the material for the second electrode 617, various types of metals, alloys, electrically conductive compounds, mixtures thereof, or the like can be used. If the second electrode is used as a cathode, it is preferable that the second electrode be formed using, among such materials, any of metals, alloys, electrically conductive compounds, or mixtures thereof, or the like having a low work function (preferably, a work function of 3.8 eV or less). For example, there are elements belonging to Group 1 and Group 2 of the periodic table, that is, alkali metals such as lithium (Li) and cesium (Cs) and alkaline earth metals such as magnesium (Mg), calcium (Ca), and strontium (Sr), alloys thereof (e.g., MgAg, AlLi), and the like. When light generated in the EL layer 616 is transmitted through the second electrode 617, the second electrode 617 can also be formed using a stack of a thin metal film with a small thickness and a transparent conductive film (indium oxide-tin oxide (ITO), indium oxide-tin oxide containing silicon or silicon oxide, indium oxide-zinc oxide (IZO), indium oxide containing tungsten oxide and zinc oxide (IWZO), or the like).

Furthermore, by attaching the sealing substrate 604 and the element substrate 610 to each other with the sealing material 605, a light-emitting element 618 is provided in the space 607 surrounded by the element substrate 610, the sealing substrate 604, and the sealing material 605. Note that the space 607 is filled with a filler. There are also cases where the space 607 may be filled with an inert gas (such as nitrogen or argon) as such a filler, or where the space 607 may be filled with the sealing material 605.

Note that as the sealing material 605, an epoxy-based resin is preferably used. In addition, it is preferable that such a material allows as little moisture or oxygen as possible to permeate. Further, as the sealing substrate 604, a plastic substrate formed using fiberglass-reinforced plastics (FRP), polyvinyl fluoride (PVF), polyester, acrylic, or the like can be used instead of a glass substrate or a quartz substrate.

As described above, the light-emitting device including a light-emitting element of the present invention can be obtained.

A light-emitting device of the present invention includes any of the light-emitting elements described in Embodiment Modes 1 and 2. Therefore, a light-emitting device that is hard to deteriorate and has long lifetime can be obtained.

As described above, an active matrix light-emitting device which controls driving of a light-emitting element with a transistor is described in this embodiment mode; however, the present invention can also be applied to a passive matrix light-emitting device. FIGS. 7A and 7B illustrate a passive matrix light-emitting device manufactured according to the present invention. Note that FIG 7A is a perspective view of the light-emitting device and FIG 7B is a cross-sectional view of FIG 7A taken along a line X-Y. In FIGS. 7A and 7B, an EL layer 955 is provided between an electrode 952 and an electrode 956 over a substrate 951. The end portion of the electrode 952 is covered with an insulating layer 953. In addition, a partition layer 954 is provided over the insulating layer 953. The sidewalls of the partition layer 954 slope so that the distance between one sidewall and the other sidewall gradually decreases toward the surface of the substrate. In other words, a cross section taken along the direction of the short side of the partition layer 954 is trapezoidal, and the lower side (a side in contact with the insulating layer 953, which is one of a pair of parallel sides of the trapezoidal cross section) is shorter than the upper side (a side not in contact with the insulating layer 953, which is the other of the pair of parallel sides). Providing the partition layer 954 in this manner enables patterning of the cathode. In addition, as for a passive matrix light-emitting device, a light-emitting device with long lifetime can be obtained by including a light-emitting element with a small amount of deterioration and long lifetime according to the present invention.

Note that this embodiment mode can be combined with any of the other embodiment modes as appropriate.

(Embodiment Mode 5)

In this embodiment mode, electronic devices of the present invention, which includes the light-emitting device described in Embodiment Mode 3 as a part, will be described. Electronic devices of the present invention include any of the light-emitting elements described in Embodiment Modes 1 and 2 and a display portion with long lifetime.

As examples of the electronic devices manufactured using the light-emitting device of the present invention, there are televisions, cameras such as video cameras and digital cameras, goggle type displays, navigation systems, audio replay devices (e.g., car audio systems and audio systems), computers, game machines, portable information terminals (e.g., mobile computers, cellular phones, portable game machines, and electronic book readers), image replay devices in which a recording medium is provided (specifically, devices that are capable of replaying recording media such as digital versatile discs (DVDs) and equipped with a display device that can display an image), and the like. Specific examples of these electronic devices are illustrated in FIGS. 8A to 8D.

FIG 8A illustrates a television device of this embodiment mode, which includes a housing 9101, a supporting base 9102, a display portion 9103, speaker portions 9104, a video input terminal 9105, and the like. In the display portion 9103 of this television device, light-emitting elements similar to those described in Embodiment Modes 1 and 2 are arranged in matrix. The features of the light-emitting elements are a small amount of deterioration and long lifetime. The display portion 9103 including the light-emitting elements has features similar to those of the light-emitting elements. Accordingly, in this television device, the amount of image display deterioration is small. With such features, functional circuitry for deterioration compensation in the television device can be greatly reduced or downsized; accordingly, a reduction in the size and weight of the housing 9101 and the supporting base 9102 can be achieved. In the television device of this embodiment mode, high image quality and the reduction in size and weight are achieved; thus, a product that is suitable for living environment can be provided.

FIG 8B illustrates a computer of this embodiment mode, which includes a main body 9201, a housing 9202, a display portion 9203, a keyboard 9204, an external connection port 9205, a pointing device 9206, and the like. In the display portion 9203 of this computer, light-emitting elements similar to those described in Embodiment Modes I and 2 are arranged in matrix. The features of the light-emitting element are a small amount of deterioration and long lifetime. The display portion 9203 including the light-emitting elements has features similar to those of the light-emitting elements. Accordingly, in this computer, the amount of image display deterioration is small. With such features, functional circuitry for deterioration compensation in the computer can be greatly reduced or downsized; accordingly, a reduction in the size and weight of the main body 9201 and the housing 9202 can be achieved. In the computer of this embodiment mode, high image quality and the reduction in size and weight are achieved; thus, a product that is suitable for environment can be provided.

FIG 8C illustrates a camera of this embodiment mode, which includes a main body 9301, a display portion 9302, a housing 9303, an external connection port 9304, a remote control receiving portion 9305, an image receiving portion 9306, a battery 9307, an audio input portion 9308, operation keys 9309, an eyepiece portion 9310, and the like. In the display portion 9302 of this camera, light-emitting elements similar to those described in Embodiment Modes 1 and 2 are arranged in matrix. The features of the light-emitting elements are a small amount of deterioration and long lifetime. The display portion 9302 including the light-emitting elements has features similar to those of the light-emitting elements. Accordingly, in this camera, the amount of image display deterioration is small. With such features, functional circuitry for deterioration compensation in the camera can be greatly reduced or downsized; accordingly, a reduction in the size and weight of the main body 9301 can be achieved. In the camera of this embodiment mode, high image quality and the reduction in size and weight are achieved; thus, a product that is suitable for being carried can be provided.

FIG 8D illustrates a cellular phone of this embodiment mode, which includes a main body 9401, a housing 9402, a display portion 9403, an audio input portion 9404, an audio output portion 9405, operation keys 9406, an external connection port 9407, an antenna 9408, and the like. In the display portion 9403 of this cellular phone, light-emitting elements similar to those described in Embodiment Modes 1 and 2 are arranged in matrix. The features of the light-emitting elements are a small amount of deterioration and long lifetime. The display portion 9403 including the light-emitting elements has features similar to those of the light-emitting elements. Accordingly, in this cellular phone, the amount of image display deterioration is small. With such features, functional circuitry for deterioration compensation in the cellular phone can be greatly reduced or downsized; accordingly, a reduction in the size and weight of the main body 9401 and the housing 9402 can be achieved. In the cellular phone of this embodiment mode, high image quality and the reduction in size and weight are achieved; thus, a product that is suitable for being carried can be provided.

FIGS. 9A to 9C illustrate an example of a cellular phone having a structure, which is different from the structure of the cellular phone in FIG 8D. FIG 9A is a front view, FIG 9B is a rear view, and FIG 9C is a development view. The cellular phone in FIGS. 9A to 9C is a so-called smartphone which has both a function of a phone and a function of a portable information terminal, and incorporates a computer to conduct a variety of data processing in addition to voice calls.

The cellular phone illustrated in FIGS. 9A to 9C includes two housings 1001 and 1002. The housing 1001 includes a display portion 1101, a speaker 1102, a microphone 1103, operation keys 1104, a pointing device 1105, a camera lens 1106, an external connection terminal 1107, and the like, while the housing 1002 includes an earphone terminal 1008, a keyboard 1201, an external memory slot 1202, a camera lens 1203, a light 1204, and the like. In addition, an antenna is incorporated in the housing 1001.

In addition to the above structure, the cellular phone may incorporate a non-contact IC chip, a small-sized memory device, or the like.

In the display portion 1101, the light-emitting device described in Embodiment Mode 3 can be incorporated, and a display direction can be changed as appropriate depending on the usage mode. The cellular phone is provided with the camera lens 1106 and the display portion 1101 on one surface to be used as a videophone. Further, a still image and a moving image can be taken with the camera lens 1203 and the light 1204, using the display portion 1101 as a viewfinder. The speaker 1102 and the microphone 1103 can be used for video calls, recording, replaying, and the like without being limited to voice calls. With the use of the operation keys 1104, making and receiving calls, inputting simple information such as e-mail or the like, scrolling the screen, moving the cursor, and the like are possible. Furthermore, the housing 1001 and the housing 1002 (FIG 9A) which are overlapped with each other can slide as illustrated in FIG 9C, so that the cellular phone can be used as a portable information terminal. In this case, smooth operation can be conducted using the keyboard 1201 and the pointing device 1105. The external connection terminal 1107 can be connected to an AC adaptor and various types of cables such as a USB cable, and charging, data communication with a computer, and the like are possible. Furthermore, a large amount of data can be stored and moved by inserting a storage medium into the external memory slot 1202.

In addition to the above functions, the cellular phone may include an infrared communication function, a television receiving function, or the like.

FIG 10 illustrates an audio replay device, specifically, a car audio system which includes a main body 701, a display portion 702, and operation switches 703 and 704. The display portion 702 can be formed by using the light-emitting device (passive matrix type or active matrix type) described in Embodiment Mode 3. Further, this display portion 702 may be formed using a segment type light-emitting device. In any case, by using the light-emitting element according to the present invention, a display portion having long lifetime can be formed with the use of a vehicle power source (12 V to 42 V). Furthermore, although this embodiment mode describes an in-car audio system, the light-emitting device according to the present invention may also be used in portable audio systems or audio systems for home use.

FIG 11 illustrates a digital player as an example of an audio system. The digital player illustrated in FIG 11 includes a main body 710, a display portion 711, a memory portion 712, an operation portion 713, a pair of earphones 714, and the like. Note that a pair of headphones or wireless earphones can be used instead of the pair of earphones 714. The display portion 711 can be formed by using the light-emitting device (passive matrix type or active matrix type) described in Embodiment Mode 3. Further, the display portion 711 may be formed using a segment type light-emitting device. In any case, the use of a light-emitting element of the present invention makes it possible to form a display portion with long lifetime, which can display images even when using a secondary battery (e.g., a nickel-hydrogen battery). As the memory portion 712, a hard disk or a nonvolatile memory is used. For example, by using a NAND-type nonvolatile memory with a recording capacity of 20 to 200 gigabytes (GB) and by operating the operating portion 713, an image or a sound (music) can be recorded and replayed. Note that in the display portion 702 shown in FIG 10 and the display portion 711, white characters are displayed against a black background, and accordingly power consumption can be reduced. This is particularly effective for portable audio systems.

As described above, the applicable range of the light-emitting device manufactured by applying the present invention is wide so that the light-emitting device can be applied to electronic devices in a wide variety of fields. By applying the present invention, an electronic device that has a display portion with a small amount of deterioration and long lifetime can be manufactured.

A light-emitting device to which the present invention is applied can also be used as a lighting apparatus. One mode of using a light-emitting element to which the present invention is applied as a lighting apparatus is described using FIG 12.

FIG 12 illustrates a liquid crystal display device using the light-emitting device to which the present invention is applied as a backlight, as an example of the electronic device using a light-emitting device according to the present invention as a lighting apparatus. The liquid crystal display device illustrated in FIG 12 includes a housing 901, a liquid crystal layer 902, a backlight 903, and a housing 904, and the liquid crystal layer 902 is connected to a driver IC 905. Further, the light-emitting device to which the present invention is applied is used as the backlight 903, and a current is supplied through a terminal 906.

Because the light-emitting device according to the present invention is thin and has long lifetime, a reduction in the thickness and an increase in the lifetime of a liquid crystal display device is possible by using a light-emitting device according to the present invention as a backlight of the liquid crystal display device. Moreover, a light-emitting device according to the present invention is a plane emission type lighting apparatus and can have a large area. Thus, the backlight can have a large area, and a liquid crystal display device having a large area can also be obtained.

FIG 13 illustrates an example in which a light-emitting device according to the present invention is used as a desk lamp, which is one of lighting apparatuses. The desk lamp illustrated in FIG 13 includes a housing 2001 and a light source 2002, and a light-emitting device of the present invention is used as the light source 2002. Because a light-emitting device of the present invention has long lifetime, the desk lamp also has long lifetime.

FIG 14 illustrates an example in which a light-emitting device to which the present invention is applied is used as an interior lighting apparatus 3001. Because a light-emitting device of the present invention can have a large area, a light-emitting device of the present invention can be used as a lighting apparatus having a large area. Moreover, because a light-emitting device of the present invention has long lifetime, a light-emitting device of the present invention can be used as a lighting apparatus that has long lifetime. In a room where a light-emitting device to which the present invention is applied is thus used as the interior lighting apparatus 3001, a television device 3002 according to the present invention as illustrated in FIG 8A may be placed, so that public broadcasting or movies can be watched there. In such a case, since both devices have long lifetime, the frequency of replacement of the lighting apparatus and the television device can be reduced, whereby environmental load can be reduced.

Note that this embodiment mode can be combined with any of the other embodiment modes as appropriate.

[Example 1]

In this example, the oxidation reaction characteristics of compounds that were used for control layers for controlling hole transport of light-emitting elements fabricated in Examples described later were measured by cyclic voltammetry (CV). The compounds are 4,4'-bis[*N*-(1-naphthyl)-*N*-phenylamino]blphenyl (abbreviation: NPB or α-NPD), *N,N'*-(quinoxaline-2,3-diyldi-4,1-phenylene)bis(*N*-phenyl-1,1'-biphenyl-4-amine) (abbreviation: BPAPQ), 4,4',4''-tris [*N*-(1-naphthyl)-*N*-phenylamino]triphenylamine (abbreviation: 1'-TNATA), and 3-[*N*-(9-phenylcarbazol-3-yl)-*N*-phenylamino]-9-phenylcarbazole (abbreviation: PCzPCAl). Further, from the measurement, the HOMO levels of NPB, BPAPQ, 1'-TNATA, and PCzPCAl were calculated. Note that an electrochemical analyzer (ALS model 600A or 600C, manufactured by BAS Inc.) was used for the measurement.

As for a solution used for the CV measurement, dehydrated dimethylformamide (DMF, product of Sigma-Aldrich Inc., 99.8 %, catalog No. 22705-6) was used as a solvent, and tetra-*n*-butylammonium perchlorate ($n\text{-}Bu_4NClO_4$, product of Tokyo Chemical Industry Co., Ltd., catalog No. T0836), which was a supporting electrolyte, was dissolved in the solvent such that the concentration of tetra-*n*-butylammonium perchlorate was 100 mmol/L. Further, the object that was to be measured was also dissolved in the solvent such that the concentration thereof was 2 mmol/L. Note that as for a substance having a low solubility, which cannot be dissolved at a concentration of 2 mmol/L, undissolved part of the substance is filtrated and then a filtrate was used for the measurement. A platinum electrode (manufactured by BAS Inc., PTE platinum electrode) was used as a working electrode, a platinum electrode (manufactured by BAS Inc., Pt counter electrode for VC-3, (5 cm)) was used as an auxiliary electrode, and an $Ag/Ag^+$ electrode (manufactured by BAS Inc., RE-7 reference electrode for nonaqueous solvent) was used as a reference electrode. Note that the measurement was conducted at room temperature (20 °C to 25 °C). In addition, the scan rate at the CV measurement was set to 0.1 V/sec in all the measurement.

(Calculation of Potential Energy of Reference Electrode with respect to Vacuum Level)

First, the potential energy (eV) of the reference electrode ($Ag/Ag^+$ electrode), which was used in this example, with respect to the vacuum level was calculated. That is, the Fermi level of the $Ag/Ag^+$ electrode was calculated. It is known that the oxidation-reduction potential of ferrocene in methanol is +0.610 [V vs. SHE] with respect to a standard hydrogen electrode (Reference: C. R. Goldsmith, et al., J. Am. Chem. Soc., Vol. 124, No. 1, pp.83-96, 2002). On the other hand, using the reference electrode used in this example, the oxidation-reduction potential of ferrocene in methanol was calculated to be +0.11 V [vs. $Ag/Ag^+$]. Thus, it was found that the potential energy of the reference electrode used in this example was lower than that of the standard hydrogen electrode by 0.50 [eV].

Here, it is known that the potential energy of the standard hydrogen electrode with respect to the vacuum level is -4.44 eV (Reference: T. Ohnishi and T. Koyama, High Molecular EL Material, Kyoritsu Shuppan, pp.64-67). Accordingly, the potential energy of the reference electrode, which was used in this example, with respect to the vacuum level could be calculated as follows:

$$-4.44 - 0.50 = -4.94\ [\mathrm{eV}].$$

(Measurement Example 1: NPB)

First, in this measurement example, calculation of HOMO level by CV measurement is described in detail. FIG 16 shows the CV measurement results of the oxidation reaction characteristics of NPB. Note that for the measurement of the oxidation reaction characteristics, the potential of the working electrode with respect to the reference electrode was scanned from -0.32 V to -1.00 V and then from 1.00 V to -0.32V

As shown in FIG 16, an oxidation peak potential $E_{pa}$ was 0.48 V and an oxidation peak potential $E_{pc}$ was 0.40 V. Therefore, a half-wave potential (an intermediate potential between $E_{pe}$ and $E_{pc}$) was calculated to be 0.44 V This shows that NPB is oxidized by an electric energy of 0.44 [V vs. $Ag/Ag^+$], and this energy corresponds to the HOMO level. Here, as described above, the potential energy of the reference electrode, which was used in this example, with respect to the vacuum level is -4.94 [eV]. Therefore, it was found that the HOMO level of NPB was calculated as follows:

$$-4.94 - 0.44 = -5.38\ [\mathrm{eV}].$$

(Measurement Example 2: BPAPQ)

FIG 17 shows CV measurement results of the oxidation reaction characteristics of BPAPQ. Note that for the measurement of the oxidation reaction characteristics, the potential of the working electrode with respect to the reference electrode was scanned from 0.15 V to 1.00 V and then from 1.00 V to 0.15 V

As shown in FIG 17, an oxidation peak potential $E_{pa}$ was 0.75 V and an oxidation peak potential $E_{pc}$ was 0.53 V Therefore, a half-wave potential (an intermediate potential between $E_{pa}$ and $E_{pc}$) can be calculated to be 0.64 V This shows that BPAPQ is oxidized by an electric energy of 0.64 [V vs. $Ag/Ag^+$], and this energy corresponds to the HOMO level. Here, as described above, the potential energy of the reference electrode, which was used in this example, with respect to the vacuum level is -4.94 [eV]. It was found that the HOMO level of BPAPQ was calculated as follows:

$$-4.94 - 0.64 = -5.58\ [\mathrm{eV}].$$

(Measurement Example 3: 1'-TNATA)

FIG 18 shows CV measurement results of the oxidation reaction characteristics of 1'-TNATA. Note that for the measurement of the oxidation reaction characteristics, the potential of the working electrode with respect to the reference electrode was scanned from -0.35 V to 0.60 V and then from 0.60 V to -0.35 V

As shown in FIG 18, an oxidation peak potential $E_{pa}$ was 0.08 V and an oxidation peak potential $E_{pc}$ was 0.00 V Therefore, a half-wave potential (an intermediate potential between $E_{pa}$ and $E_{pc}$) can be calculated to be 0.04 V This shows that 1'-TNATA was oxidized by an electric energy of 0.04 [V vs. $Ag/Ag^+$], and this energy corresponds to the HOMO level. Here, as described above, the potential energy of the reference electrode, which was used in this example, with respect to the vacuum level is -4.94 [eV]. It was found that the HOMO level of 1'-TNATA was calculated as follows:

$$-4.94 - 0.04 = -4.98\ [\mathrm{eV}].$$

(Measurement Example 4: PCzPCAl)

FIG 19 shows CV measurement results of the oxidation reaction characteristics of PCzPCAl. Note that for the

measurement of the oxidation reaction characteristics, the potential of the working electrode with respect to the reference electrode was scanned from -0.08 V to 0.45 V and then from 0.45 V to -0.08 V

As shown in FIG 19, an oxidation peak potential $E_{pa}$ was 0.28 V and an oxidation peak potential $E_{pc}$ was 0.21 V Therefore, a half-wave potential (an intermediate potential between $E_{pa}$ and $E_{pc}$) can be calculated to be 0.25 V This shows that PCzPCAl was oxidized by an electric energy of 0.25 [V vs. $Ag/Ag^+$], and this energy corresponds to the HOMO level. Here, as described above, the potential energy of the reference electrode, which was used in this example, with respect to the vacuum level is -4.94 [eV]. It was found that the HOMO level of PCzPCAl was calculated as follows:

$$-4.94 - 0.25 = -5.19\ [eV].$$

From the above measurement results, it is found that the HOMO level of 1'-TNATA is higher than the HOMO level of NPB by 0.40 [eV], that the HOMO level of 1'-TNATA is higher than the HOMO level of BPAPQ by 0.60 [eV], and that the HOMO level of PCzPCAl is higher than the HOMO level of BPAPQ by 0.39 [eV].

[Example 2]

In this example, a light-emitting element of the present invention is described using FIG 15. Structural formulae of materials used in this example are illustrated below. In this example, light-emitting elements each include a control layer 2113 in which 4,4'-bis[*N*-(1-naphthyl)-*N*-phenylamino]biphenyl (abbreviation: NPB or α-NPD) was used as a first organic compound and 4,4',4''-tris[*N*-(1-naphthyl)-*N*-phenylamino]triphenylamine (abbreviation: 1'-TNATA) was used as a second organic compound, and the lifetimes of these elements were examined while the concentration of 1'-TNATA was varied.

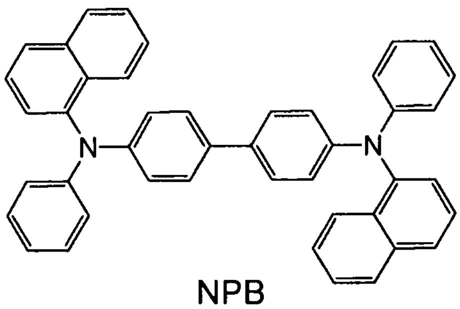

NPB

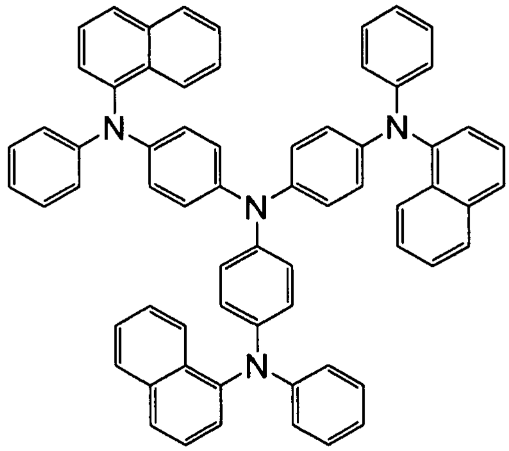

1'-TNATA

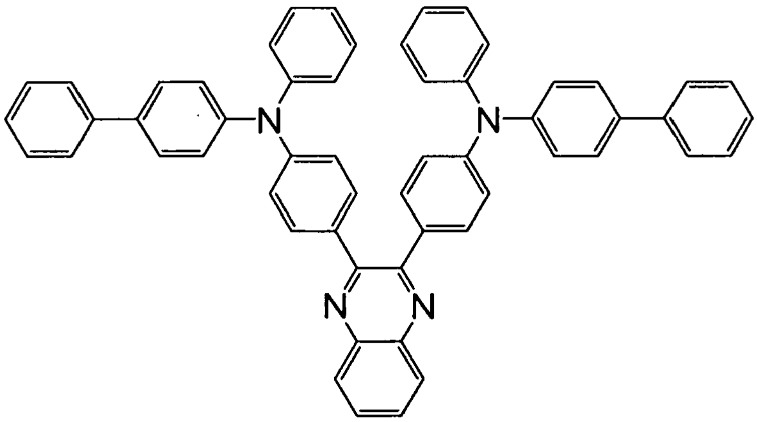

BPAPQ

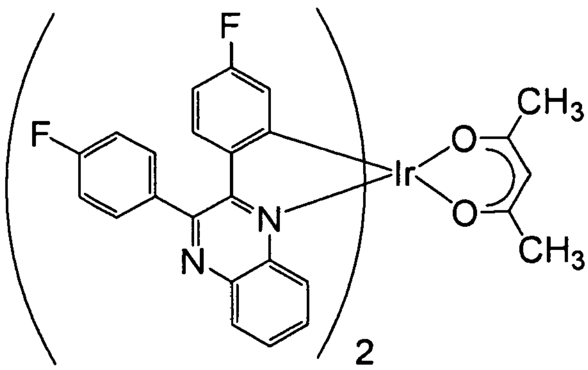

Ir(Fdpq)$_2$(acac)

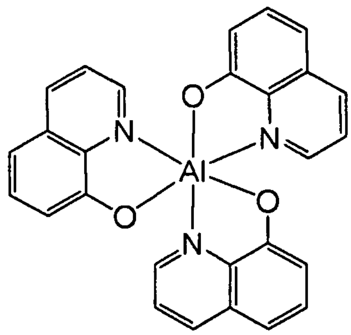

Alq

First, a method for fabricating a light-emitting element of this example is described below

(Light-Emitting Element 1)

First, a film of indium tin oxide containing silicon oxide (abbreviation: ITSO) was formed over a glass substrate 2101 by a sputtering method to form a first electrode 2102. The thickness of the first electrode 2102 was set to 110 nm. The area of the first electrode was set to 2 mm × 2 mm.

Next, the substrate provided with the first electrode 2102 was fixed to a substrate holder provided in a vacuum evaporation apparatus such that the side on which the first electrode 2102 was formed faced downward. After the pressure in a film formation chamber was reduced to approximately $10^{-4}$ Pa, a layer 2111 containing a composite material of an organic compound and an inorganic compound was formed over the first electrode 2102 by co-evaporation of 4,4'-bis[*N*-(1-naphthyl)-*N*-phenylamino]biphenyl (abbreviation: NPB) and molybdenum(VI) oxide. The thickness of the layer 2111 was 50 nm and the weight ratio of NPB to molybdenum(VI) oxide was adjusted so as to be 4:1 (= NPB:molybdenum oxide). Note that a co-evaporation method refers to an evaporation method by which evaporation is concurrently conducted from a plurality of evaporation sources in one treatment chamber.

Next, a 10 nm thick NPB film was formed over the layer 2111 containing a composite material by an evaporation method using resistance heating to form a hole-transporting layer 2112.

Then, NPB and 4,4',4"-tris[*N*-(1-naphthyl)-*N*-phenylamino]triphenylamine (abbreviation: 1'-TNATA) were co-evaporated over the hole-transporting layer 2112 to form the 10 nm thick control layer 2113 for controlling hole transport. Here, the weight ratio of NPB to 1'-TNATA was adjusted so as to be 1:0.005 (= NPB:1'-TNATA).

Then, *N,N'*-(quinoxaline-2,3-diyldi-4,1-phenylene)bis(*N*-phenyl-1,1'-biphenyl-4-amine) (abbreviation: BPAPQ) and (acetylacetonato)bis[2,3-bis(4-fluorophenyl)quinoxalinato]iridium(III) (abbreviation: $Ir(Fdpq)_2(acac)$) were co-evaporated over the control layer 2113 for controlling hole transport to form a 30 nm thick light-emitting layer 2114. Here, the weight ratio of BPAPQ to $Ir(Fdpq)_2(acac)$ was adjusted so as to be 1:0.06 (= BPAPQ:$Ir(Fdpq)_2(acac)$).

Next, a 10 nm thick tris(8-quinolinolato)aluminum(III) (abbreviation: Alq) film was formed over the light-emitting layer 2114 by an evaporation method using resistance heating to form an electron-transporting layer 2115.

Then, Alq and lithium were co-evaporated over the electron-transporting layer 2115 by an evaporation method using resistance heating to form a 50 nm thick electron-injecting layer 2116. Here, the weight ratio of Alq to Li was adjusted so as to be 1:0.01 (=Alq:Li).

Lastly, a 200 nm thick aluminum film was formed over the electron-injecting layer 2116 by an evaporation method using resistance heating to form a second electrode 2104. Thus, a light-emitting element 1 was fabricated.

(Light-Emitting Element 2)

An element having an element structure similar to that of the light-emitting element 1 was fabricated, in which the concentration of 1'-TNATA in the control layer 2113 for controlling hole transport was changed. In other words, the weight ratio of NPB to 1'-TNATA was adjusted so as to be 1:0.01 (= NPB:1'-TNATA), so that a light-emitting element 2 was fabricated. The layers other than the control layer 2113 were formed in a manner similar to that of the light-emitting element 1.

(Light-Emitting Element 3)

An element having an element structure similar to that of the light-emitting element 1 was fabricated, in which the concentration of 1'-TNATA in the control layer 2113 for controlling hole transport was changed. In other words, the weight ratio of NPB to 1'-TNATA was adjusted so as to be 1:0.05 (= NPB:1'-TNATA), so that a light-emitting element 3 was fabricated. The layers other than the control layer 2113 were formed in a manner similar to that of the light-emitting element 1.

(Light-Emitting Element 4)

An element having an element structure similar to that of the light-emitting element 1 was fabricated, in which the concentration of 1'-TNATA in the control layer 2113 for controlling hole transport was changed. In other words, the weight ratio of NPB to 1'-TNATA was adjusted so as to be 1:0.1 (= NPB:1'-TNATA), so that a light-emitting element 4 was fabricated. The layers other than the control layer 2113 were formed in a manner similar to that of the light-emitting element 1.

(Light-Emitting Element 5)

An element having an element structure similar to that of the light-emitting element 1 was fabricated, in which the concentration of 1'-TNATA in the control layer 2113 for controlling hole transport was changed. In other words, the weight ratio of NPB to 1'-TNATA was adjusted so as to be 1:0.2 (= NPB:1'-TNATA), so that a light-emitting element 5 was fabricated. The layers other than the control layer 2113 were formed in a manner similar to that of the light-emitting element 1.

(Light-Emitting Element 6)

An element having an element structure similar to that of the light-emitting element 1 was fabricated, in which the concentration of 1'-TNATA in the control layer 2113 for controlling hole transport was changed. In other words, the weight ratio of NPB to 1'-TNATA was adjusted so as to be 1:0.5 (= NPB:1'-TNATA), so that a light-emitting element 6 was fabricated. The layers other than the control layer 2113 were formed in a manner similar to that of the light-emitting element 1.

(Comparative Light-Emitting Element 7)

An element having an element structure similar to that of the light-emitting element 1 was formed, in which the material having a hole-trapping property (1'-TNATA) was not added to the control layer 2113 for controlling hole transport. In other words, for the control layer 2113 for controlling hole transport, only a 10 nm thick NPB film was formed. That is, an element having a structure was formed, in which the hole-transporting layer 2112 was formed using a 20 nm thick NPB film and the control layer 2113 for controlling hole transport was not formed. The layers other than the control layer 2113 were formed in a manner similar to that of the light-emitting element 1.

The light-emitting elements 1 to 6 and comparative light-emitting element 7 which were thus obtained were each sealed in a glove box containing a nitrogen atmosphere so as not to be exposed to air. Then, the operating characteristics of these light-emitting elements were measured. Note that the measurement was carried out at room temperature (in an atmosphere kept at 25 °C).

Table 1 below shows the values of a voltage [V], a current efficiency [cd/A], and a power efficiency [lm/W] at the time when the light-emitting elements 1 to 6 and the comparative light-emitting element 7 each emitted light at a luminance of 1000 [cd/m$^2$]. Further, Table 1 also shows the concentration (molar fraction) of 1'-TNATA in the control layer in each light-emitting element.

Table 1

| | Molar Fraction of 1'-TNATA *C* | Voltage [V] | Current Efficiency [cd/A] | Power Efficiency [1m/W] |
|---|---|---|---|---|
| Light-Emitting Element 1 | 0.0033 | 7.7 | 3.6 | 1.5 |
| Light-Emitting Element 2 | 0.0065 | 9.2 | 3.8 | 1.3 |
| Light-Emitting Element 3 | 0.032 | 11.2 | 4.1 | 1.2 |
| Light-Emitting Element 4 | 0.062 | 10.3 | 4.1 | 1.3 |
| Light-Emitting Element 5 | 0.12 | 11.4 | 4.0 | 1.1 |
| Light-Emitting Element 6 | 0.25 | 12.1 | 3.2 | 0.82 |
| Comparative Light-Emitting Element 7 | 0 | 6.6 | 2.6 | 1.3 |

As apparent from Table 1, as the concentration of 1'-TNATA as a dopant having a hole-trapping property in the control layer is increased, the driving voltage is slightly increased, and thus it is found that 1'-TNATA acts as a trap. While the driving voltage of the comparative light-emitting element 7 was low, the current efficiency thereof was low This is because Alq emitted light, since holes are transported through the light-emitting layer to reach the electron-transporting layer in a structure where a dopant having a hole-trapping property was not added to the control layer. FIGS. 20A and 20B show the emission spectra at a current of 1 mA of the light-emitting elements 1 to 6 and the comparative light-emitting element 7. Further, FIG 20B is an enlarged view of FIG 20A. As can be seen from FIGS. 20A and 20B, whereas red light emission (650 nm or less) due to $Ir(Fdpq)_2(acac)$ was obtained from each light-emitting element, green light emission (540 nm or less) due to Alq was also clearly observed from the comparative light-emitting element 7. On the other hand, in the light-emitting elements 1 to 6, it was found that as the concentration of a dopant having a hole-trapping property, 1'-TNATA, was increased, light emission form Alq was suppressed. Thus, it is understood that transport of holes through the light-emitting layer can be suppressed.

Next, continuous lighting tests were conducted in which each of these light-emitting elements was driven at a constant current with the initial luminance thereof set to 1000 [cd/m$^2$]. The results are shown in FIG 21, in which the horizontal axis represents time, and the vertical axis represents normalized luminance (1000 [cd/m$^2$] was assumed as 100 %). From these results, a luminance decay rate $D_{250hr}$ [%] after 250 hours was obtained as a barometer of the

lifetime of each element, and shown in Table 2 below. Table 2 also shows the values of a molar fraction *C*, $\Delta E$ (= 0.40 [eV]) calculated in Example 1, and the parameter *X* obtained by assigning the thickness *L* (= 10 [nm]) of the control layer to the equation (1). Note that as for the luminance decay rate $D_{250hr}$ [%], if the luminance is decayed by 10 % after 250 hours (i.e., the luminance is reduced to 90 % of the initial luminance), *D* becomes 10.

Table 2

| | Molar Fraction of 1'-TNATA *C* | Parameter *X* | $D_{250hr}$ [%] |
|---|---|---|---|
| Light-Emitting Element 1 | 0.0033 | $1.0 \times 10^{-2}$ | 10.3 |
| Light-Emitting Element 2 | 0.0065 | $5.5 \times 10^{-3}$ | 9.3 |
| Light-Emitting Element 3 | 0.032 | $7.4 \times 10^{-4}$ | 5.9 |
| Light-Emitting Element 4 | 0.062 | $2.2 \times 10^{-4}$ | 3.7 |
| Light-Emitting Element 5 | 0.12 | $5.3 \times 10^{-5}$ | 4.4 |
| Light-Emitting Element 6 | 0.25 | $6.0 \times 10^{-6}$ | 7.1 |
| Comparative Light-Emitting Element 7 | 0 | 0.1 | 11.9 |

FIG 24 is a graph in which the horizontal axis represents the parameter *X* and the vertical axis represents $D_{250hr}$ based on the data in Table 2. As compared with the comparative light-emitting element 7 (whose parameter *X* was 0.1) to which 1'-TNATA was not added, the lifetime of each of the light-emitting elements 1 to 6 to which 1'-TNATA was added was found to be improved. Further, from FIG 24, it is found that there is an optimum concentration range with a peak at around *X* which is $2 \times 10^{-4}$ for obtaining the effect of improving lifetime.

[Example 3]

In this example, a light-emitting element of the present invention is described using FIG 15. In this example, light-emitting elements each include the control layer 2113 in which *N*,*N'*-(quinoxaline-2,3-diyldi-4,1-phenylene)bis(*N*-phenyl-1,1'-biphenyl-4-amine) (abbreviation: BPAPQ) was used as the first organic compound and, as in Example 2, 4,4',4''-tris[*N*-(1-naphthyl)-*N*-phenylamino]triphenylamine (abbreviation: 1'-TNATA) was used as the second organic compound, and the lifetimes of these elements were examined while the concentration of 1'-TNATA was varied. Note that the structural formulae of the molecular structures of the used materials, which have been illustrated in Example 2, are omitted.

(Light-Emitting Element 8)

A light-emitting element 8 was fabricated in a manner similar to that of the light-emitting element 1 of Example 2, except the structure of the control layer 2113 formed as described below In other words, for the light-emitting element 8, by co-evaporation of *N*,*N'*-(quinoxaline-2,3-diyldi-4,1-phenylene)bis(*N*-phenyl-1,1'-biphenyl-4-amine) (abbreviation: BPAPQ) and 4,4',4''-tris[*N*-(1-naphthyl)-*N*-phenylamino]triphenylamine (abbreviation: 1'-TNATA), the 10 nm thick control layer 2113 for controlling hole transport was formed over the hole-transporting layer 2112. Here, the weight ratio of BPAPQ to 1'-TNATA was adjusted so as to be 1:0.005 (= BPAPQ: 1'-TNATA).

(Light-Emitting Element 9)

An element having an element structure similar to that of the light-emitting element 8 was fabricated, in which the concentration of 1'-TNATA in the control layer 2113 for controlling hole transport was changed. In other words, the weight ratio of BPAPQ to 1'-TNATA was adjusted so as to be 1:0.01 (= BPAPQ:1'-TNATA), so that a light-emitting element 9 was fabricated. The layers other than the control layer 2113 were formed in a manner similar to that of the

light-emitting element 8.

(Light-Emitting Element 10)

An element having an element structure similar to that of the light-emitting element 8 was fabricated, in which the concentration of 1'-TNATA in the control layer 2113 for controlling hole transport was changed. In other words, the weight ratio of BPAPQ to 1'-TNATA was adjusted so as to be 1:0.05 (= BPAPQ:1'-TNATA), so that a light-emitting element 10 was fabricated. The layers other than the control layer 2113 were formed in a manner similar to that of the light-emitting element 8.

(Light-Emitting Element 11)

An element having an element structure similar to that of the light-emitting element 8 was fabricated, in which the concentration of 1'-TNATA in the control layer 2113 for controlling hole transport was changed. In other words, the weight ratio of BPAPQ to 1'-TNATA was adjusted so as to be 1:0.1 (= BPAPQ:1'-TNATA), so that a light-emitting element 11 was fabricated. The layers other than the control layer 2113 were formed in a manner similar to that of the light-emitting element 8.

(Light-Emitting Element 12)

An element having an element structure similar to that of the light-emitting element 8 was fabricated, in which the concentration of 1'-TNATA in the control layer 2113 for controlling hole transport was changed. In other words, the weight ratio of BPAPQ to 1'-TNATA was adjusted so as to be 1:0.2 (= BPAPQ:1'-TNATA), so that a light-emitting element 12 was fabricated. The layers other than the control layer 2113 were formed in a manner similar to that of the light-emitting element 8.

(Light-Emitting Element 13)

An element having an element structure similar to that of the light-emitting element 8 was fabricated, in which the concentration of 1'-TNATA in the control layer 2113 for controlling hole transport was changed. In other words, the weight ratio of BPAPQ to 1'-TNATA was adjusted so as to be 1:0.5 (= BPAPQ:1'-TNATA), so that a light-emitting element 13 was fabricated. The layers other than the control layer 2113 were formed in a manner similar to that of the light-emitting element 8.

The thus obtained light-emitting elements 8 to 13 were each sealed in a glove box containing a nitrogen atmosphere so as not to be exposed to air. Then, the operating characteristics of these light-emitting elements were measured. Note that the measurement was carried out at room temperature (in an atmosphere kept at 25 °C).

Table 3 below shows the values of a voltage [V], a current efficiency [cd/A], and a power efficiency [lm/W] at the time when the light-emitting elements 8 to 13 each emitted light at a luminance of 1000 [cd/m$^2$]. Further, Table 3 also shows the concentration (molar fraction) of 1'-TNATA in the control layer in each light-emitting element. As apparent from Table 3, as the concentration of 1'-TNATA as a dopant having a hole-trapping property in the control layer is increased, the driving voltage is slightly increased, and thus it is found that 1'-TNATA acts as a trap. Note that, like the light-emitting elements 1 to 6 of Example 2, red light emission due to $Ir(Fdpq)_2(acac)$ was obtained from each light-emitting element and green light emission due to Alq was hardly observed.

Table 3

| | Molar Fraction of 1'-TNATA *C* | Voltage [V] | Current Efficiency [cd/A] | Power Efficiency [1m/W] |
|---|---|---|---|---|
| Light-Emitting Element 8 | 0.0043 | 9.8 | 3.7 | 1.2 |
| Light-Emitting Element 9 | 0.0085 | 12.1 | 3.6 | 0.94 |
| Light-Emitting Element 10 | 0.041 | 13.8 | 2.9 | 0.67 |

(continued)

| | Molar Fraction of 1'-TNATA $C$ | Voltage [V] | Current Efficiency [cd/A] | Power Efficiency [1m/W] |
|---|---|---|---|---|
| Light-Emitting Element 11 | 0.079 | 13.3 | 3.1 | 0.73 |
| Light-Emitting Element 12 | 0.15 | 12.1 | 3.4 | 0.89 |
| Light-Emitting Element 13 | 0.30 | 11.3 | 3.5 | 0.96 |

Next, continuous lighting tests were conducted in which each of these light-emitting elements was driven at a constant current with the initial luminance thereof set to 1000 [cd/m$^2$]. The results are shown in FIG 22, in which the horizontal axis represents time, and the vertical axis represents normalized luminance (1000 [cd/m$^2$] was assumed as 100 %). From these results, a luminance decay rate $D_{250hr}$ [%] after 250 hours was obtained as a barometer of the lifetime of each element, and shown in Table 4 below. Table 4 also shows the values of a molar fraction $C$, $\Delta E$ (= 0.60 [eV]) calculated in Example 1, and the parameter $X$ obtained by assigning the thickness $L$ (= 10 [nm]) of the control layer to the equation (1). Note that as for the luminance decay rate $D_{250hr}$ [%], if the luminance is decayed by 10 % after 250 hours (i.e., the luminance is reduced to 90 % of the initial luminance), $D$ becomes 10.

Table 4

| | Molar Fraction of 1'-TNATA $C$ | Parameter $X$ | $D_{250hr}$ [%] |
|---|---|---|---|
| Light-Emitting Element 8 | 0.0043 | $2.3 \times 10^{-3}$ | 5.0 |
| Light-Emitting Element 9 | 0.0085 | $8.7 \times 10^{-4}$ | 4.3 |
| Light-Emitting Element 10 | 0.041 | $3.3 \times 10^{-5}$ | 5.7 |
| Light-Emitting Element 11 | 0.079 | $4.7 \times 10^{-6}$ | 5.4 |
| Light-Emitting Element 12 | 0.15 | $4.8 \times 10^{-7}$ | 5.8 |
| Light-Emitting Element 13 | 0.30 | $1.8 \times 10^{-8}$ | 5.8 |

FIG 25 is a graph in which the horizontal axis represents the parameter $X$ and the vertical axis represents $D_{250hr}$ based on the data in Table 4. It is found that the amount of deterioration of each of the light-emitting elements 8 to 13 is small and that there is an optimum concentration range with a peak at around $X$ which is $9 \times 10^{-4}$ for obtaining the effect of improving lifetime.

[Example 4]

In this example, a light-emitting element of the present invention is described using FIG 15. In this example, light-emitting elements each include the control layer 2113 in which, as in Example 3, *N*,*N'*-(quinoxaline-2,3-diyldi-4,1-phenylene)bis(*N*-phenyl-1,1'-biphenyl-4-amine) (abbreviation: BPAPQ) was used as the first organic compound and 3-[*N*-(9-phenylcarbazol-3-yl)-*N*-phenylamino]-9-phenylcarbazole (abbreviation: PCzPCAl) was used as the second organic compound, and the lifetimes of these elements were examined while the concentration of PCzPCAl was varied. Methods of fabricating the light-emitting elements of this example are described below.

A Structural formula of the material used in this example is illustrated below. Note that the structural formulae of the materials, which have already been illustrated, are omitted.

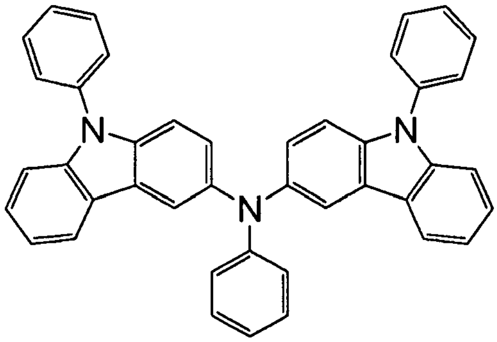

PCzPCA1

(Light-Emitting Element 14)

A light-emitting element 14 was fabricated in a manner similar to that of the light-emitting element 1 of Example 2, except the structure of the control layer 2113 as described below In other words, for the light-emitting element 14, by co-evaporation of *N,N'*-(quinoxaline-2,3-diyldi-4,1-phenylene)bis(*N*-phenyl-1,1'-biphenyl-4-amine) (abbreviation: BPAPQ) and 3-[*N*-(9-phenylcarbazol-3-yl)-*N*-phenylamino]-9-phenylcarbazole (abbreviation: PCzPCAl), the 10 nm thick control layer 2113 for controlling hole transport was formed over the hole-transporting layer 2112. Here, the weight ratio of BPAPQ to PCzPCAl was adjusted so as to be 1:0.005 (= BPAPQ:PCzPCAl).

(Light-Emitting Element 15)

An element having an element structure similar to that of the light-emitting element 14 was fabricated, in which the concentration of PCzPCAl in the control layer 2113 for controlling hole transport was changed. In other words, the weight ratio of BPAPQ to PCzPCAl was adjusted so as to be 1:0.01 (= BPAPQ:PCzPCAl), so that a light-emitting element 15 was fabricated. The layers other than the control layer 2113 were formed in a manner similar to that of the light-emitting element 14.

(Light-Emitting Element 16)

An element having an element structure similar to that of the light-emitting element 14 was fabricated, in which the concentration of PCzPCAl in the control layer 2113 for controlling hole transport was changed. In other words, the weight ratio of BPAPQ to PCzPCAl was adjusted so as to be 1:0.05 (= BPAPQ:PCzPCAl), so that a light-emitting element 16 was fabricated. The layers other than the control layer 2113 were formed in a manner similar to that of the light-emitting element 14.

(Light-Emitting Element 17)

An element having an element structure similar to that of the light-emitting element 14 was fabricated, in which the concentration of PCzPCAl in the control layer 2113 for controlling hole transport was changed. In other words, the weight ratio of BPAPQ to PCzPCAl was adjusted so as to be 1:0.1 (= BPAPQ:PCzPCAl), so that a light-emitting element 17 was fabricated. The layers other than the control layer 2113 were formed in a manner similar to that of the light-emitting element 14.

(Light-Emitting Element 18)

An element having an element structure similar to that of the light-emitting element 14 was fabricated, in which the concentration of PCzPCAl in the control layer 2113 for controlling hole transport was changed. In other words, the weight ratio of BPAPQ to PCzPCAl was adjusted so as to be 1:0.2 (= BPAPQ:PCzPCAl), so that a light-emitting element 18 was fabricated. The layers other than the control layer 2113 were formed in a manner similar to that of the light-emitting element 14.

(Light-Emitting Element 19)

An element having an element structure similar to that of the light-emitting element 14 was fabricated, in which the concentration of PCzPCAl in the control layer 2113 for controlling hole transport was changed. In other words, the weight ratio of BPAPQ to PCzPCAl was adjusted so as to be 1:0.5 (= BPAPQ:PCzPCAl), so that a light-emitting element 19 was fabricated. The layers other than the control layer 2113 were formed in a manner similar to that of the light-emitting element 14.

The thus obtained light-emitting elements 14 to 19 were each sealed in a glove box containing a nitrogen atmosphere so as not to be exposed to air. Then, the operating characteristics of these light-emitting elements were measured. Note that the measurement was carried out at room temperature (in an atmosphere kept at 25 °C).

Table 5 below shows the values of a voltage [V], a current efficiency [cd/A], and a power efficiency [lm/W] at the time when the light-emitting elements 14 to 19 each emitted light at a luminance of 1000 [cd/$m^2$]. Further, Table 5 also shows the concentration (molar fraction) of PCzPCAl in the control layer in each light-emitting element. As apparent from Table 5, as the concentration of PCzPCAl as a dopant having a hole-trapping property in the control layer is increased, the driving voltage is slightly increased, and thus it is found that PCzPCAl acts as a trap. Note that, like the light-emitting elements 1 to 6 of Example 2, red light emission due to $Ir(Fdpq)_2(acac)$ was obtained from each light-emitting element and green light emission due to Alq was hardly observed.

Table 5

| | Molar Fraction of PCzPCAl *C* | Voltage [V] | Current Efficiency [cd/A] | Power Efficiency [1m/W] |
|---|---|---|---|---|
| Light-Emitting Element 14 | 0.0066 | 5.7 | 3.2 | 1.8 |
| Light-Emitting Element 15 | 0.013 | 6.3 | 3.6 | 1.8 |
| Light-Emitting Element 16 | 0.063 | 7.4 | 4.1 | 1.8 |
| Light-Emitting Element 17 | 0.12 | 7.4 | 4.1 | 1.8 |
| Light-Emitting Element 18 | 0.21 | 7.1 | 4.0 | 1.8 |
| Light-Emitting Element 19 | 0.40 | 6.8 | 3.8 | 1.8 |

Next, continuous lighting tests were conducted in which each of these light-emitting elements was driven at a constant current with the initial luminance thereof set to 1000 [cd/$m^2$]. The results are shown in FIG 23, in which the horizontal axis represents time, and the vertical axis represents normalized luminance (1000 [cd/$m^2$] was assumed as 100 %). From these results, a luminance decay rate $D_{250hr}$ [%] after 250 hours was obtained as a barometer of the lifetime of each element, and shown in Table 6 below. Table 6 also shows the values of a molar fraction *C*, $\Delta E$ (= 0.39 [eV]) calculated in Example 1, and the parameter *X* obtained by assigning the thickness *L* (= 10 [nm]) of the control layer to the equation (1). Note that as for the luminance decay rate $D_{250hr}$ [%], if the luminance is decayed by 10 % after 250 hours (i.e., the luminance is reduced to 90 % of the initial luminance), *D* becomes 10.

Table 6

| | Molar Fraction of PCzPCAl *C* | Parameter *X* | $D_{250hr}$ [%] |
|---|---|---|---|
| Light-Emitting Element 14 | 0.0066 | $5.9 \times 10^{-3}$ | 9.3 |
| Light-Emitting Element 15 | 0.013 | $2.8 \times 10^{-3}$ | 9.6 |

(continued)

| | Molar Fraction of PCzPCAl $C$ | Parameter $X$ | $D_{250hr}$ [%] |
|---|---|---|---|
| Light-Emitting Element 16 | 0.063 | $2.5 \times 10^{-4}$ | 7.2 |
| Light-Emitting Element 17 | 0.12 | $6.1 \times 10^{-5}$ | 6.4 |
| Light-Emitting Element 18 | 0.21 | $1.3 \times 10^{-5}$ | 6.5 |
| Light-Emitting Element 19 | 0.40 | $1.5 \times 10^{-6}$ | 7.2 |

FIG 26 is a graph in which the horizontal axis represents the parameter $X$ and the vertical axis represents $D_{250hr}$, based on the data in Table 6. It is found that deterioration of each of the light-emitting elements 14 to 19 is small and that there is an optimum concentration range with a peak at around $X$ which is $6 \times 10^{-5}$ for obtaining the effect of improving lifetime.

[Example 5]

In this example, the effectiveness and valid range of the parameter $X$ were evaluated based on the data obtained in Example 2 to 4.

FIG 27 is a graph showing all the data obtained by plotting the relationship between the parameter $X$ and the decay time $D_{250hr}$ of Examples 2 to 4. As apparent from FIG 27, the plots show that there is an optimum range of the parameter $X$ for reducing the value of $D_{250hr}$, which is common to all the elements. The present inventors were surprised that such a rule has been found, despite the fact that the data in Example 2 to 4 were obtained with the substances that are different in kind and concentration. From FIG 27, the parameter $X$ in the range of from $1 \times 10^{-8}$ to $1 \times 10^{-2}$ is effective for an increase in the lifetime of an element.

In particular, it is found that the range of the parameter $X$, in which $D_{250hr}$ falls below 10 %, is $1 \times 10^{-3}$ or less. When $D_{250h}$, falls below 10 %, although depending on the shape of a luminance decay curve, it is thought that a luminance half-life period of about 10000 or more hours is obtained, which is practical. Note that, as can be seen from Tables 1 to 6 in Examples 2 to 4, the parameter $X$ is preferably $1 \times 10^{-5}$ or more since the driving voltage tends to increase when the parameter $X$ increases too much. Thus, the parameter $X$ preferably ranges from $1 \times 10^{-5}$ to $1 \times 10^{-3}$.

As described above, the parameter $X$ is highly effective, and its valid range can be shown experimentally.

The present application is based on Japanese Patent Application serial No. 2008-032467 filed with Japan Patent Office on February 13, 2008, the entire contents of which are hereby incorporated by reference.

## Claims

**1.** A light-emitting element comprising:

a first electrode;
a second electrode; and
a light-emitting layer and a control layer between the first electrode and the second electrode,

wherein:

the control layer includes a first organic compound and a second organic compound;
an amount of the included first organic compound is larger than an amount of the included second organic compound;
the first organic compound is an organic compound having a hole-transporting property;
a highest occupied molecular orbital level (HOMO level) of the second organic compound is higher than the highest occupied molecular orbital level (HOMO level) of the first organic compound; and
a value of a parameter $X$ obtained by an equation (1) ranges from $1 \times 10^{-8}$ to $I \times 10^{-2}$, and

$$X = \frac{1}{L}\left\{\exp\left(-\frac{\Delta E}{kT}\right)\right\}^{\sqrt[3]{C}} \quad \cdots (1)$$

where $\Delta E$ is an energy difference [eV] between the HOMO level of the first organic compound and the HOMO level of the second organic compound, $C$ is a molar fraction [dimensionless term] of the second organic compound, $L$ is a thickness [nm] of the control layer, $k$ is a Boltzmann constant (= $8.61 \times 10^{-5}$ [eV.K$^{-1}$]), and $T$ is a temperature (= 300 [K]).

**2.** A light-emitting element comprising:

a first electrode;
a second electrode; and
a light-emitting layer and a control layer between the first electrode and the second electrode,

wherein:

the control layer includes a first organic compound and a second organic compound;
an amount of the included first organic compound is larger than an amount of the included second organic compound;
the first organic compound is an organic compound having a hole-transporting property;
a highest occupied molecular orbital level (HOMO level) of the second organic compound is higher than the highest occupied molecular orbital level (HOMO level) of the first organic compound; and
a value of a parameter $X$ obtained by an equation (1) ranges from $1 \times 10^{-5}$ to $1 \times 10^{-3}$, and

$$X = \frac{1}{L}\left\{\exp\left(-\frac{\Delta E}{kT}\right)\right\}^{\sqrt[3]{C}} \quad \cdots (1)$$

where $\Delta E$ is an energy difference [eV] between the HOMO level of the first organic compound and the HOMO level of the second organic compound, $C$ is a molar fraction [dimensionless term] of the second organic compound, $L$ is a thickness [nm] of the control layer, $k$ is a Boltzmann constant (= $8.61 \times 10^{-5}$ [eV.K$^{-1}$]), and $T$ is a temperature (= 300 [K]).

**3.** The light-emitting element according to claim 1 or claim 2, wherein a thickness L of the control layer is greater than or equal to 5 nm and less than or equal to 20 nm.

**4.** The light-emitting element according to claim 1 or claim 2, wherein a mobility of the first organic compound ranges from $10^{-6}$ [cm$^2$/Vs] to $10^{-2}$ [cm$^2$/Vs].

**5.** The light-emitting element according to claim 1 or claim 2, wherein a mobility of the first organic compound ranges from $10^{-5}$ [cm$^2$Vs] to $10^{-3}$ [cm$^2$/Vs].

**6.** The light-emitting element according to claim 1 or claim 2, wherein the energy difference $\Delta E$ between the HOMO level of the first organic compound and the HOMO level of the second organic compound is greater than or equal to 0.2 [eV] and less than or equal to 0.6 [eV].

**7.** The light-emitting element according to claim 1 or claim 2, wherein the control layer is provided between the light-emitting layer and the first electrode; and
light emission is obtained from the light-emitting layer by application of a voltage such that a potential of the first electrode is higher than a potential of the second electrode.

**8.** The light-emitting element according to claim 1 or claim 2, wherein the light-emitting layer has a hole-transporting property.

**9.** The light-emitting element according to claim 1 or claim 2, wherein:

the light-emitting layer includes a third organic compound and a fourth organic compound;
an amount of the included third organic compound is larger than an amount of the included fourth organic compound; and
the third organic compound has a hole-transporting property.

**10.** The light-emitting element according to claim 1 or claim 2, wherein the control layer and the light-emitting layer are in contact with each other.

**11.** A light-emitting device comprising the light-emitting element according to claim 1 or claim 2 and a control circuit configured to control light emission of the light-emitting element.

**12.** An electronic device comprising a display portion,
wherein the display portion includes the light-emitting element according to claim 1 or claim 2 and a control circuit configured to control light emission of the light-emitting element.

FIG. 1

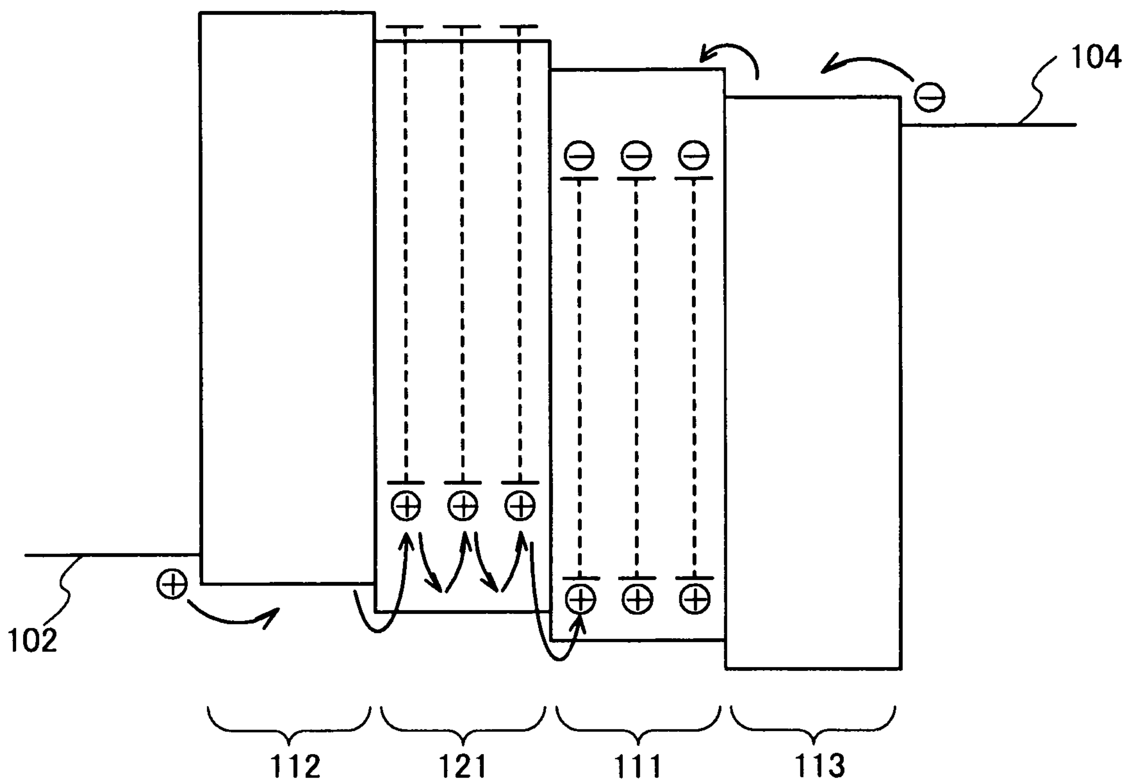

FIG. 2A

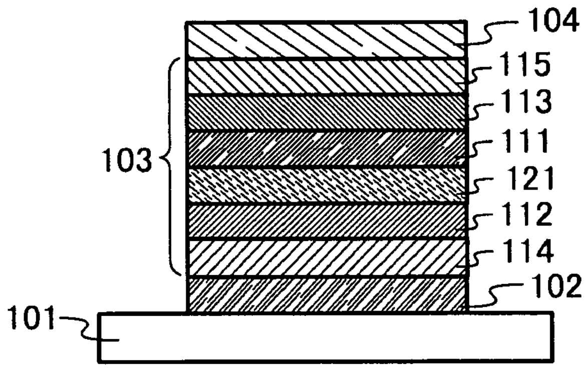
104
115
113
111
121
112
114
102
103
101

FIG. 2B

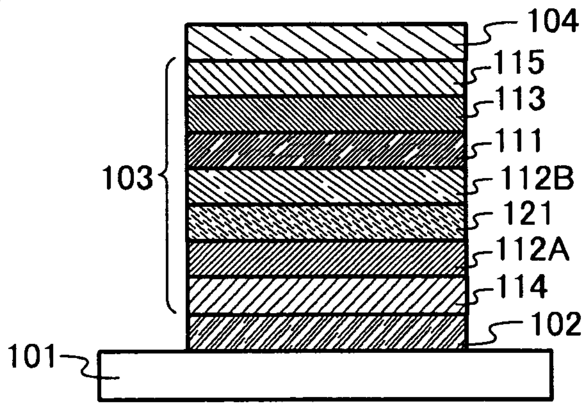
104
115
113
111
112B
121
112A
114
102
103
101

FIG. 3A

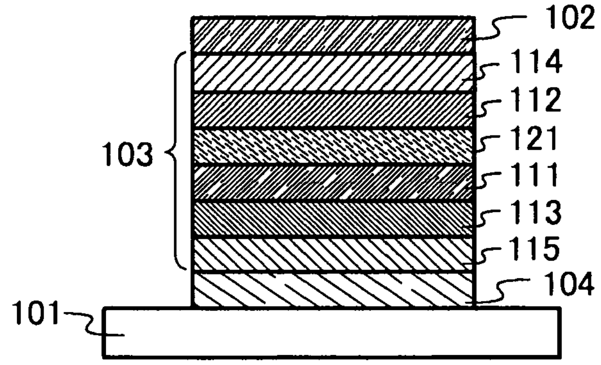
102
114
112
121
111
113
115
104
103
101

FIG. 3B

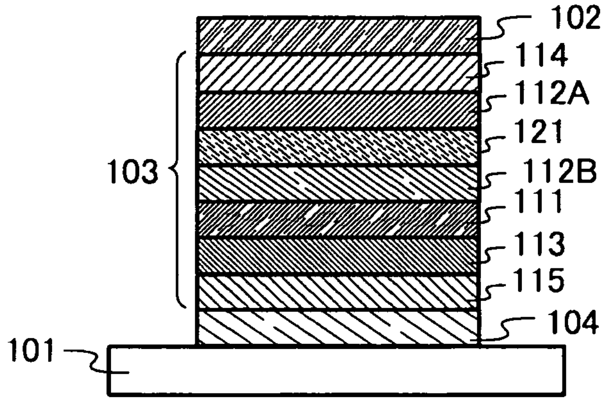
102
114
112A
121
112B
111
113
115
104
103
101

FIG. 4A

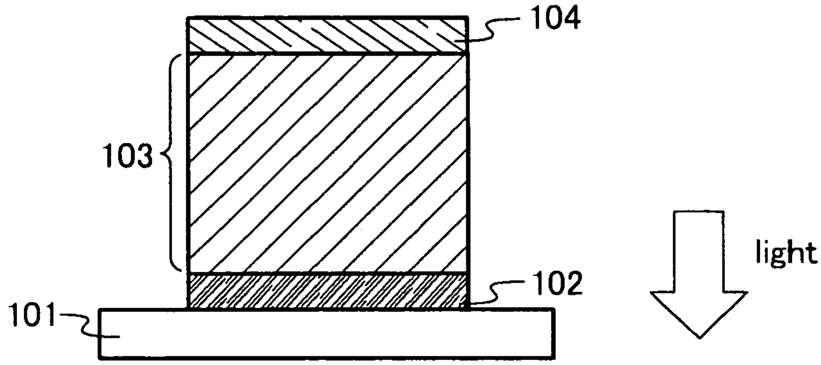


FIG. 4B

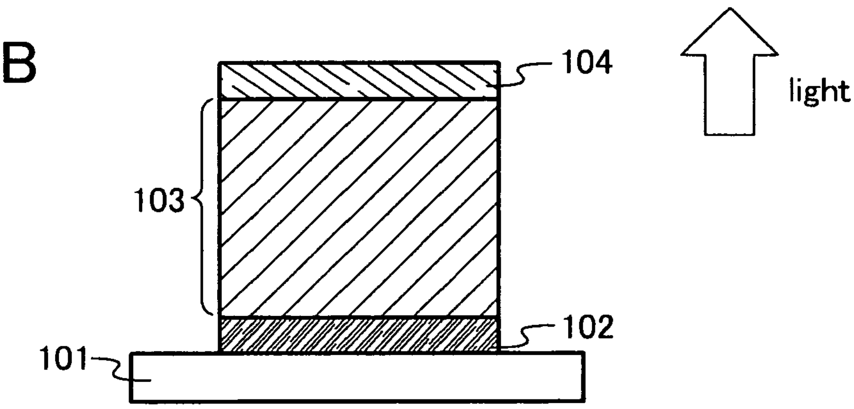


FIG. 4C

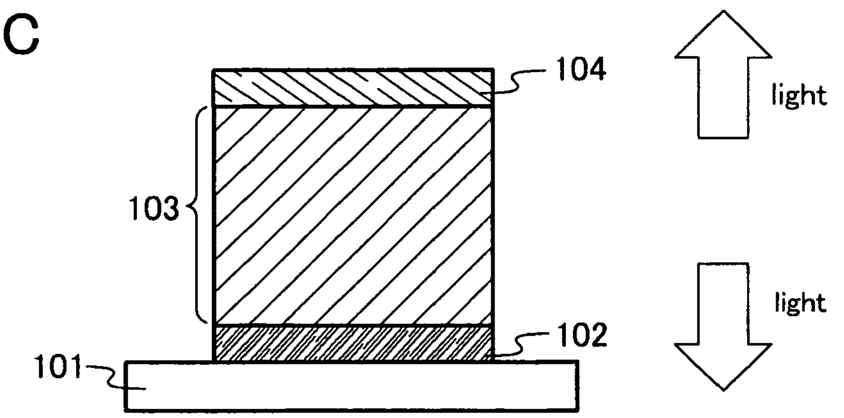

FIG. 5

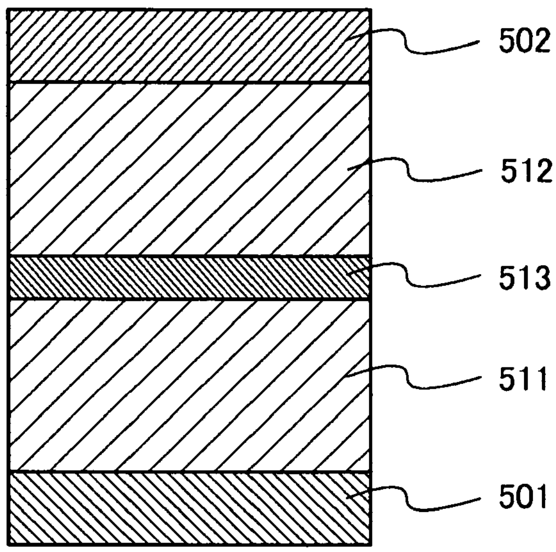

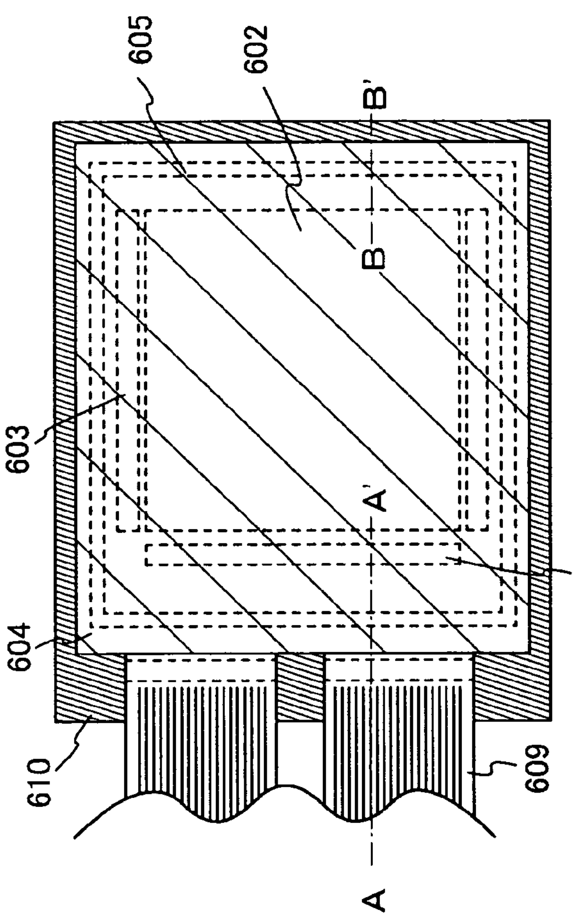
610
604
603
605
602
B'
B
A'
601
609
A

FIG. 6A

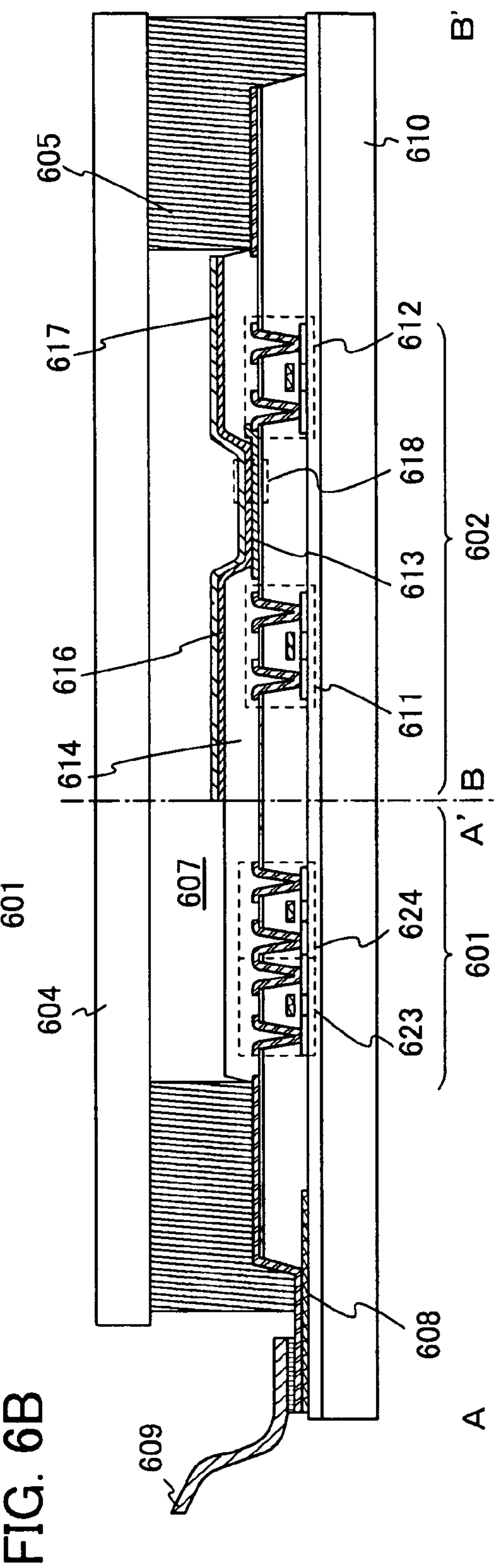
605
617
616
614
604
607
609
610
612
618
613
611
624
623
608
602
601
B'
B
A'
A

FIG. 6B

FIG. 7A

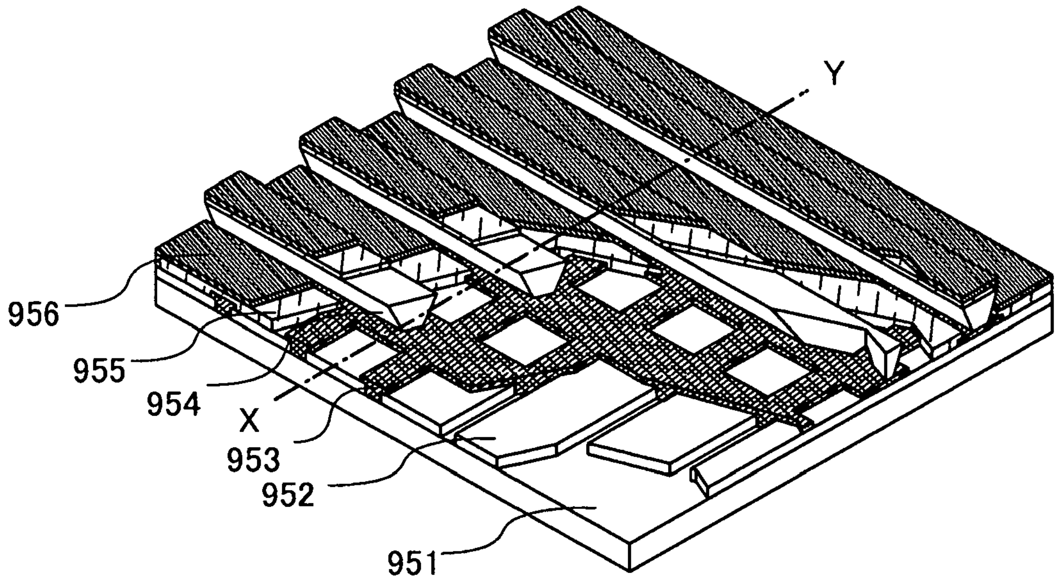
Y
956
955
954
X
953
952
951

FIG. 7B

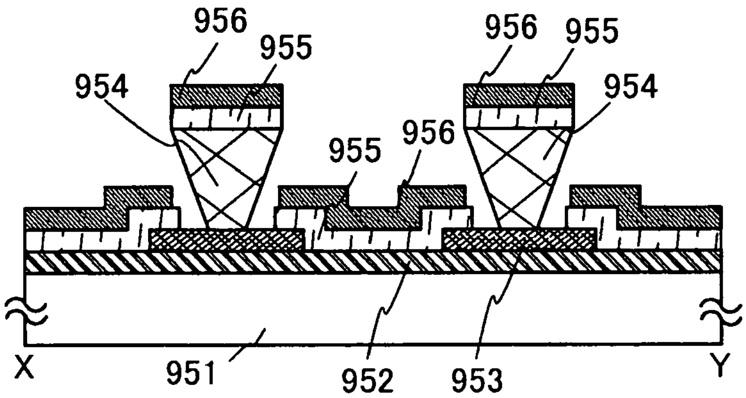
956
955
954
956
955
954
955
956
X
951
952
953
Y

FIG. 8A

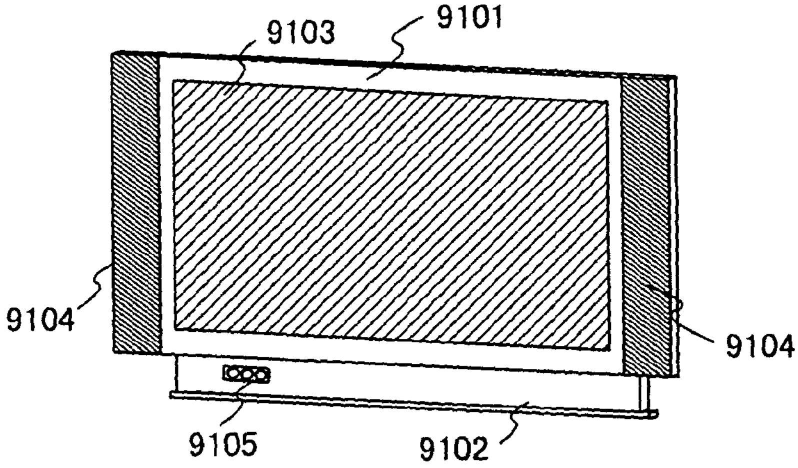


FIG. 8B

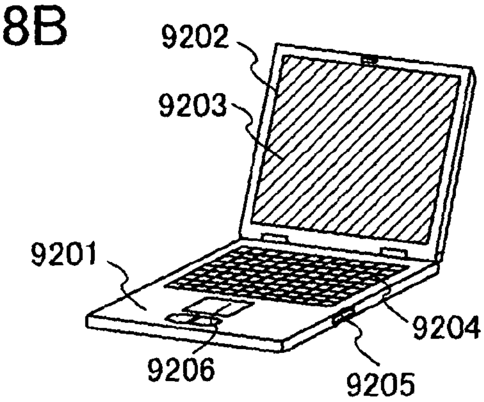


FIG. 8C

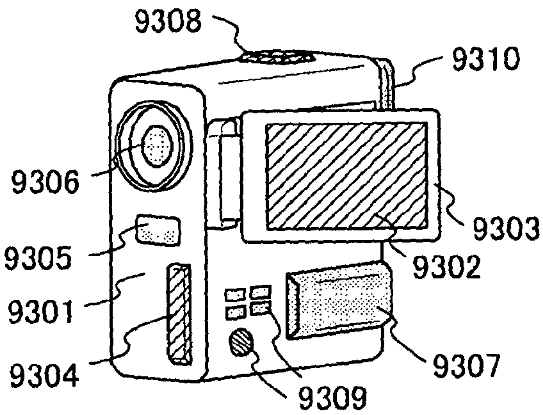


FIG. 8D

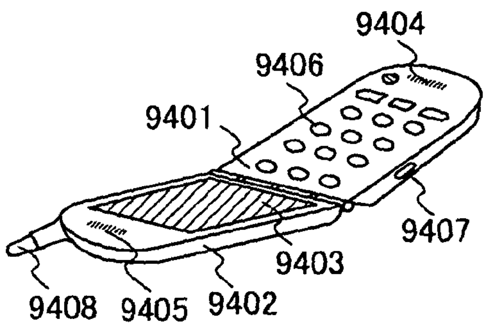

FIG. 9A

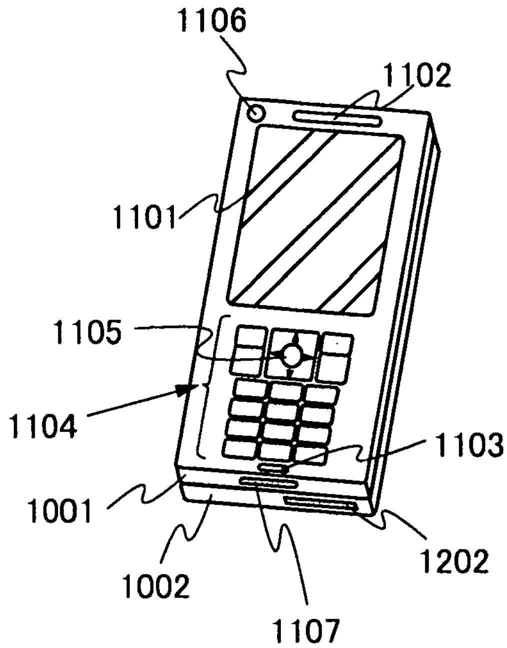


FIG. 9B

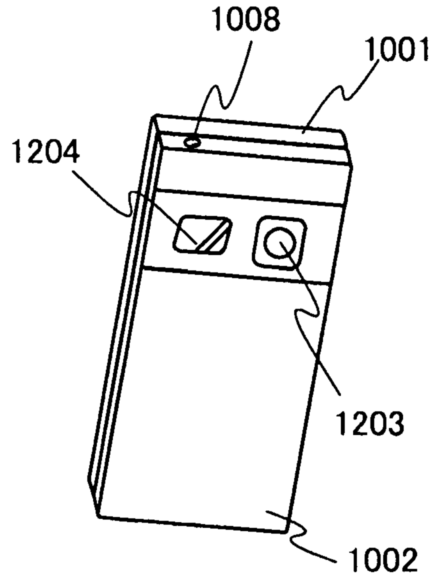


FIG. 9C

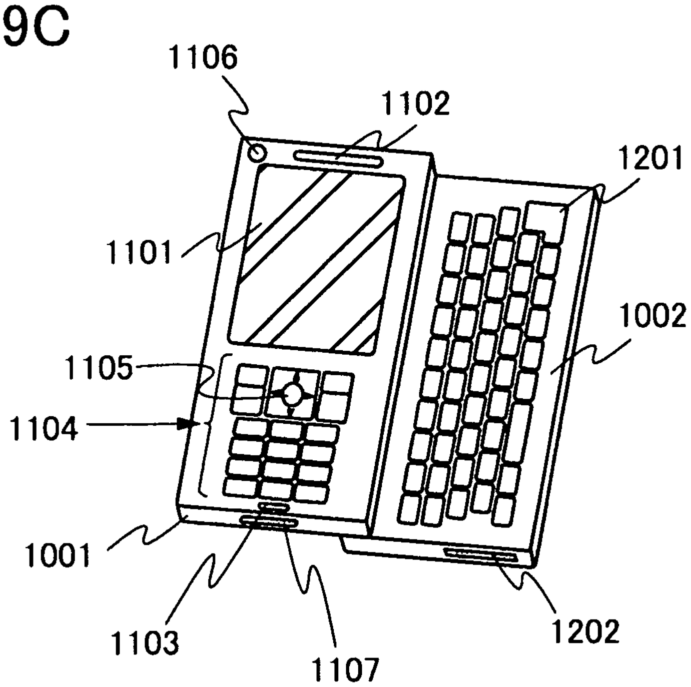

FIG. 10

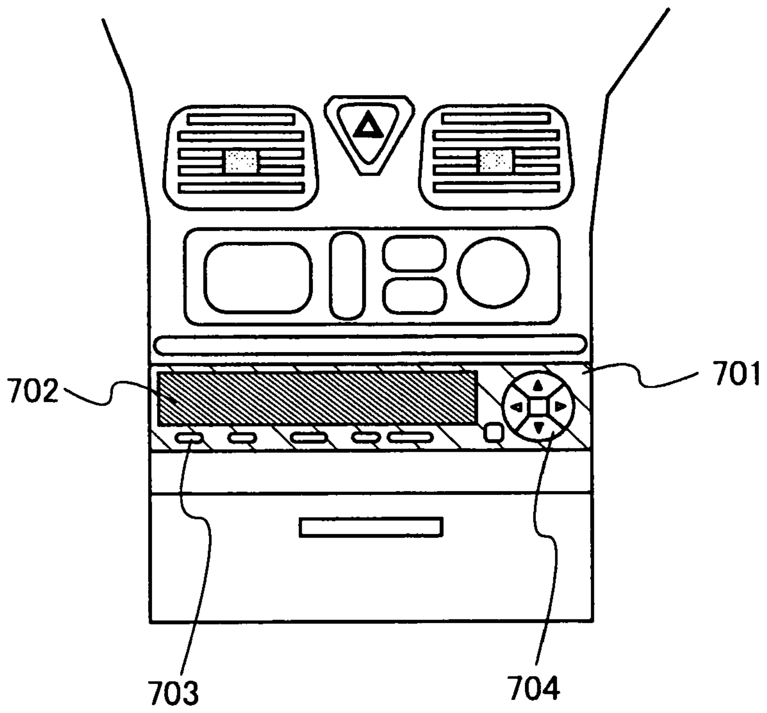

FIG. 11

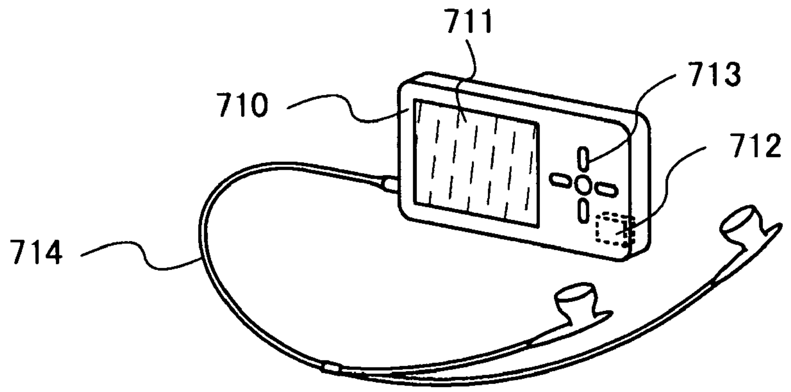

FIG. 12

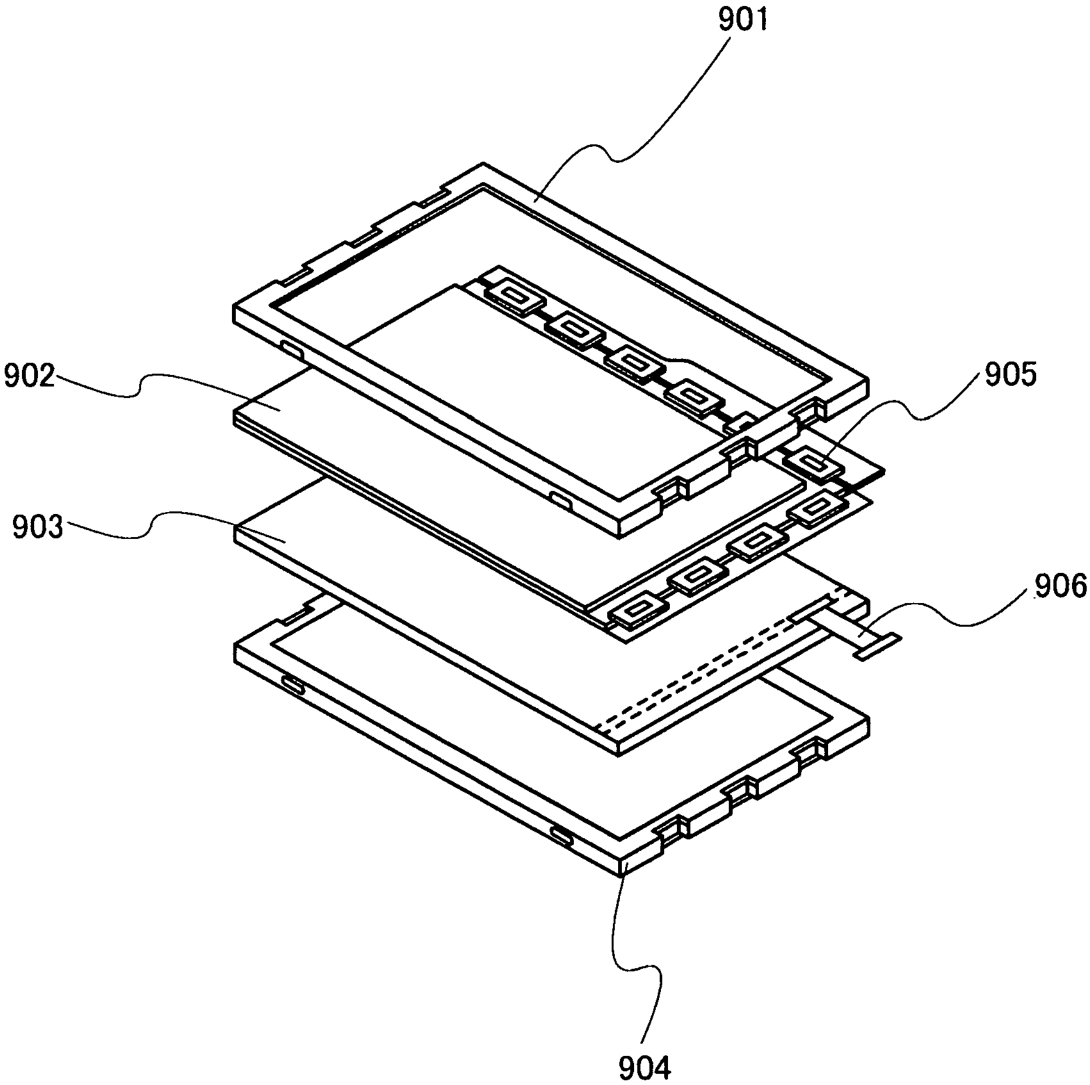

FIG. 13

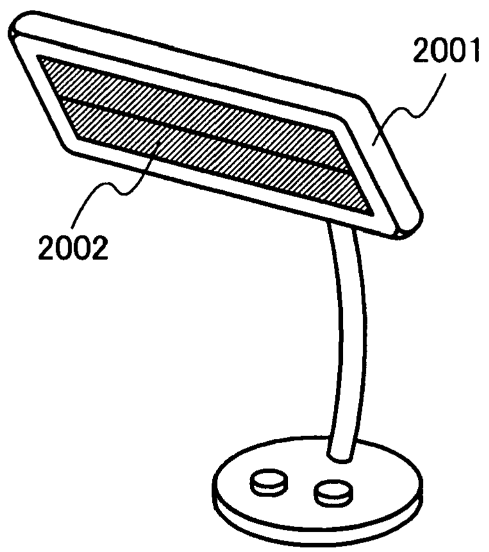

FIG. 14

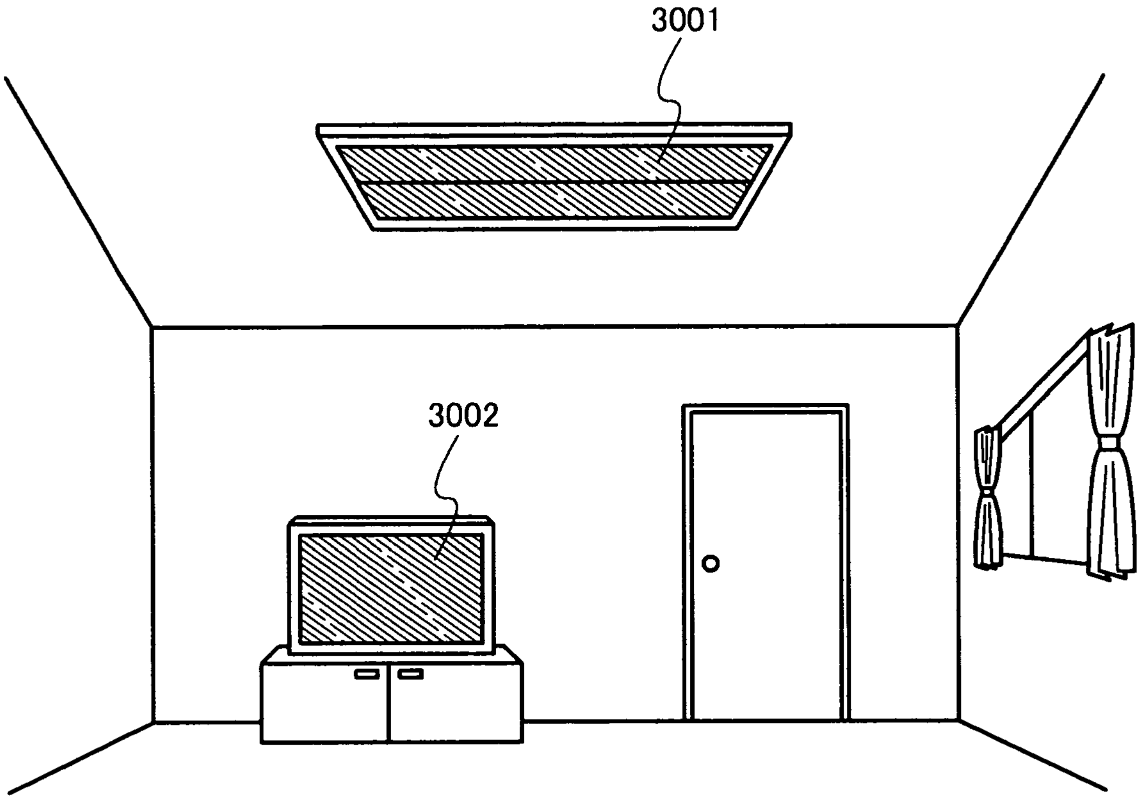

FIG. 15

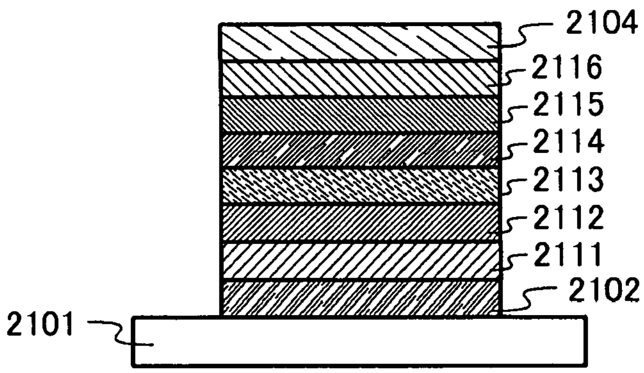

FIG.16

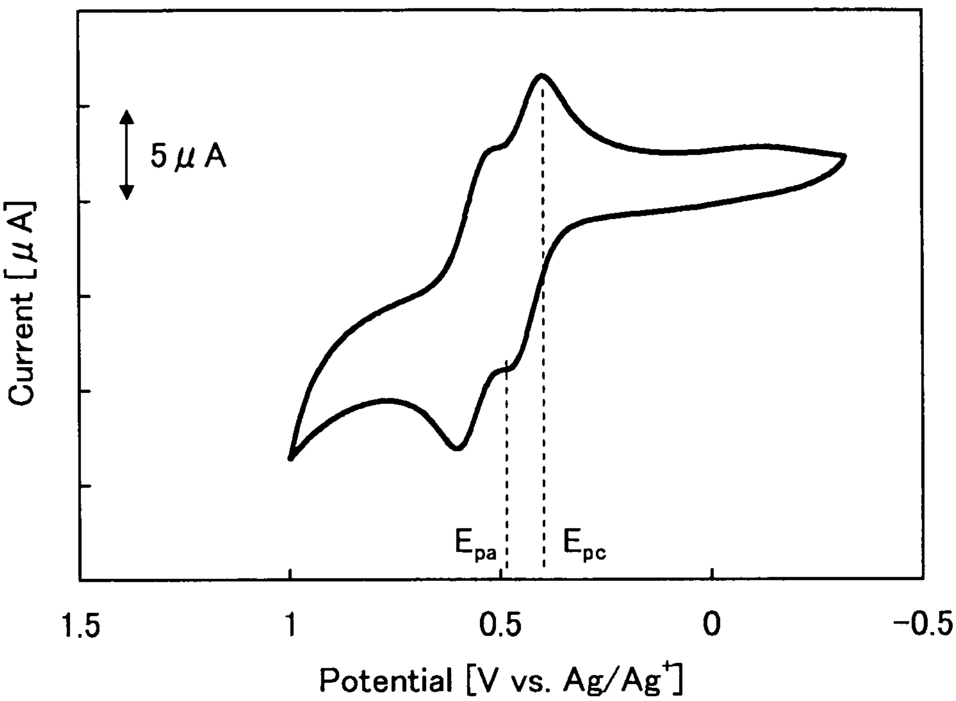

FIG. 17

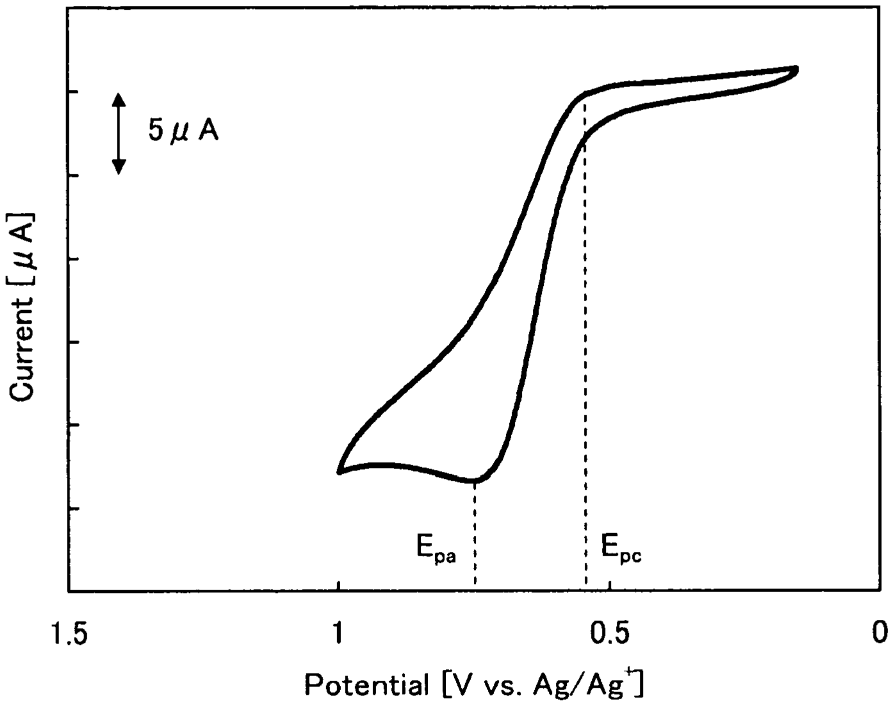

FIG. 18

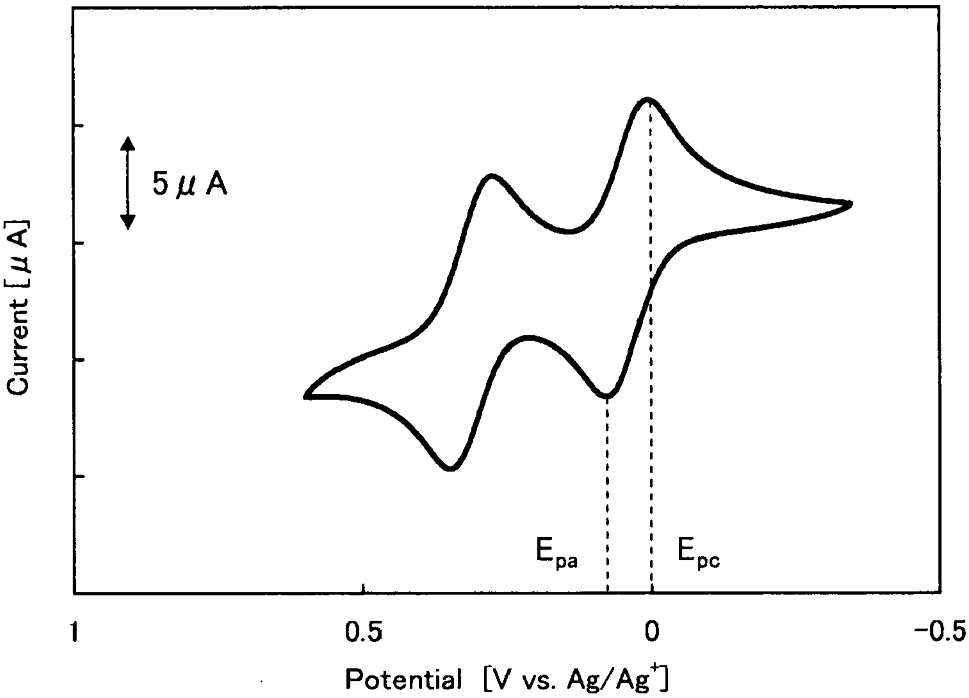

FIG. 19

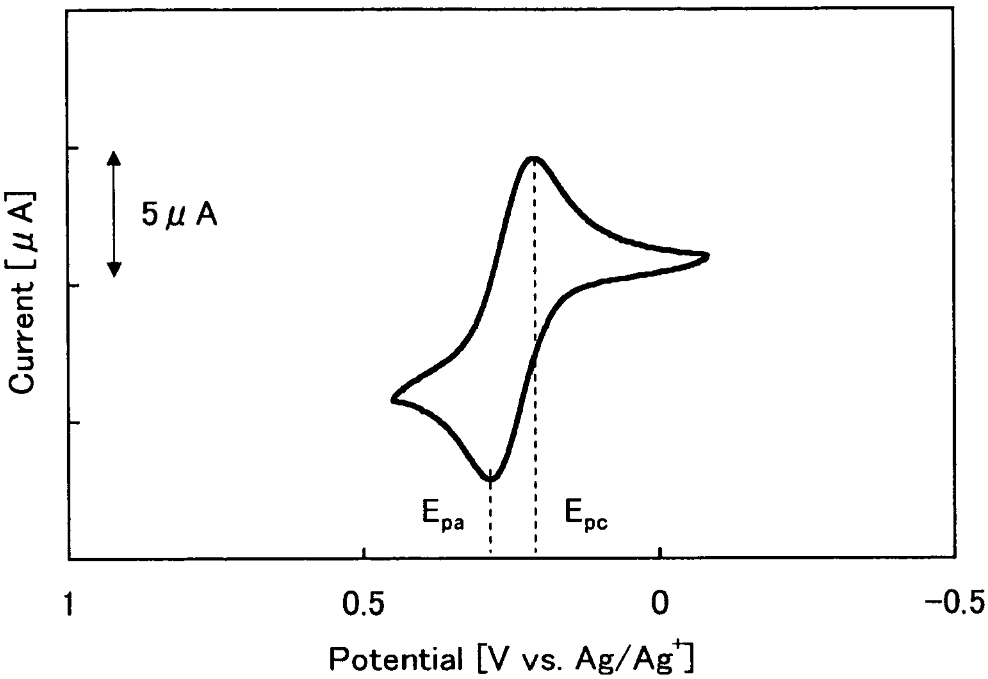

FIG. 20A

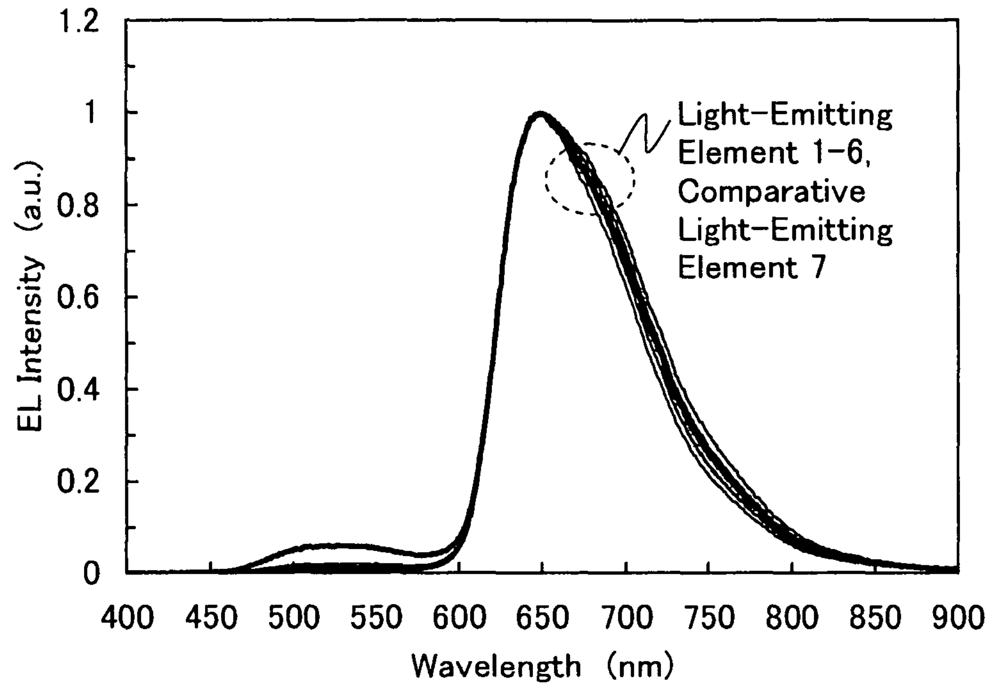


FIG. 20B

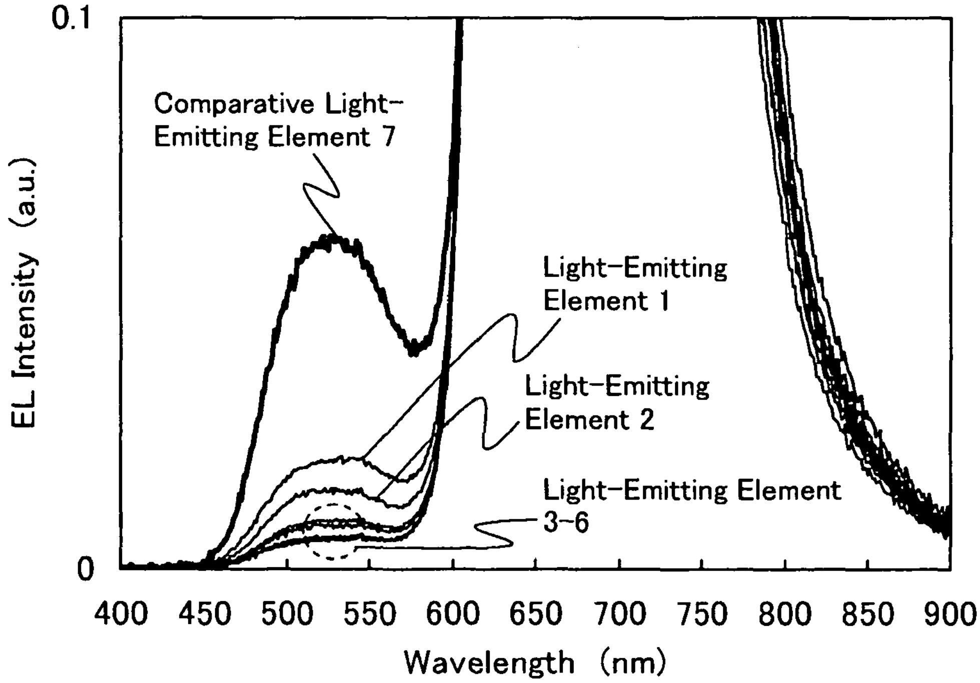

FIG. 21

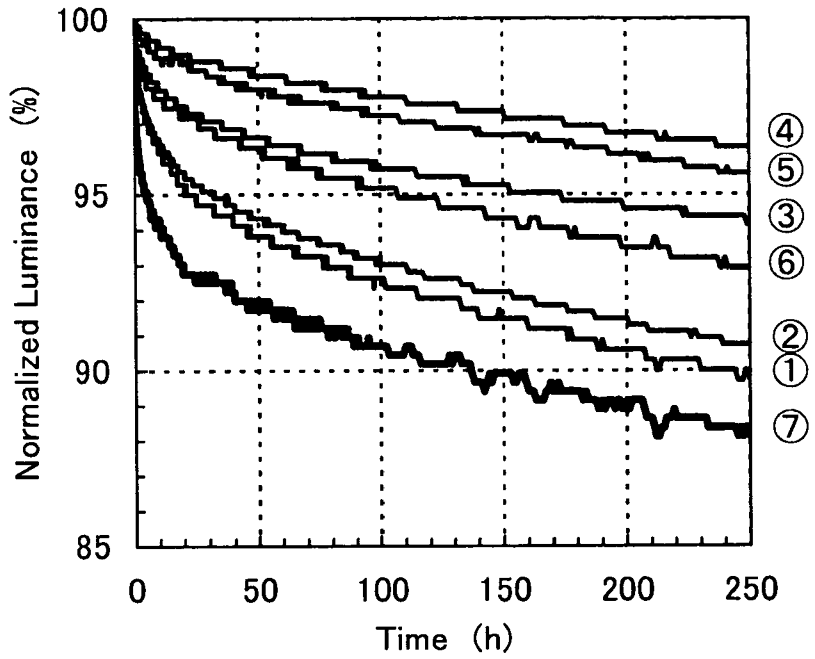


①: Light-Emitting Element 1
②: Light-Emitting Element 2
③: Light-Emitting Element 3
④: Light-Emitting Element 4
⑤: Light-Emitting Element 5
⑥: Light-Emitting Element 6
⑦: Comparative Light-Emitting Element 7

FIG. 22

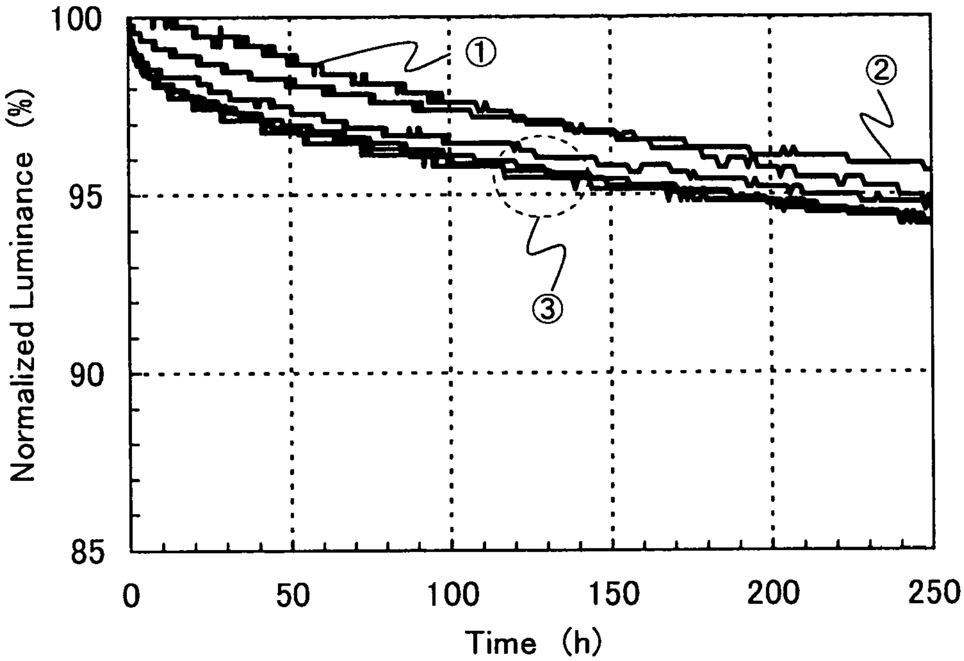


①: Light-Emitting Element 8
②: Light-Emitting Element 9
③: Light-Emitting Element 10-13

FIG. 23

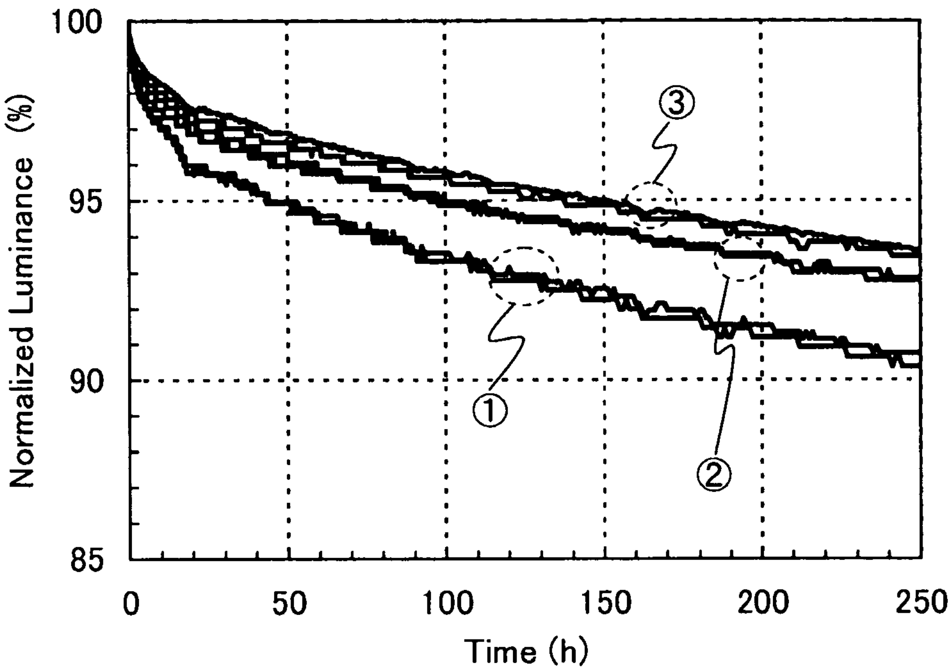


①: Light-Emitting Elements 14-15
②: Light-Emitting Elements 16, 19
③: Light-Emitting Elements 17-18

FIG. 24

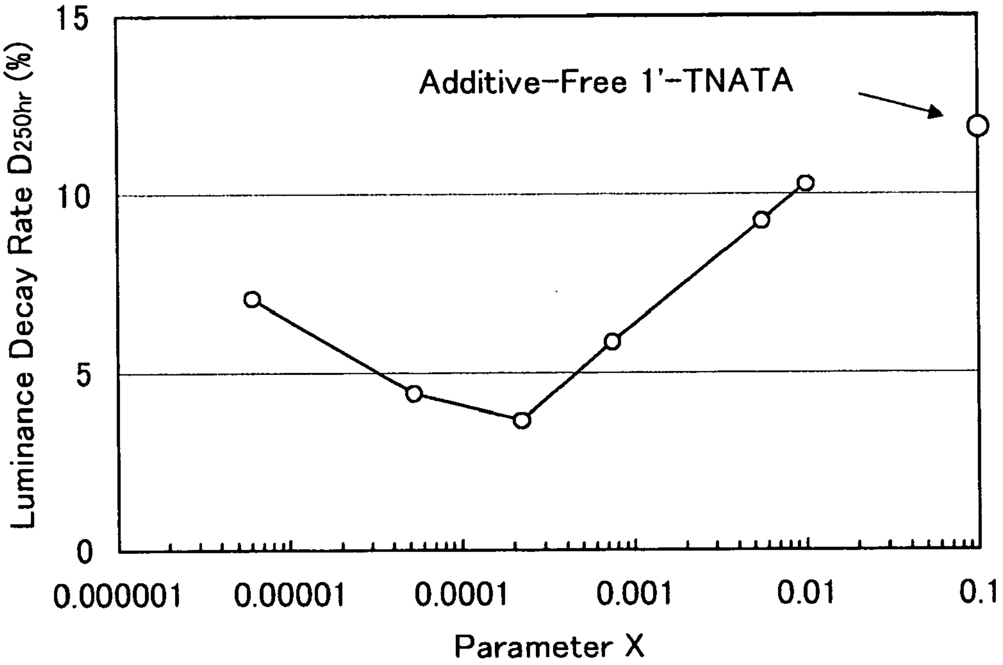
Luminance Decay Rate D250hr (%)
15
10
5
0
Additive-Free 1'-TNATA
0.000001
0.00001
0.0001
0.001
0.01
0.1
Parameter X

FIG. 25

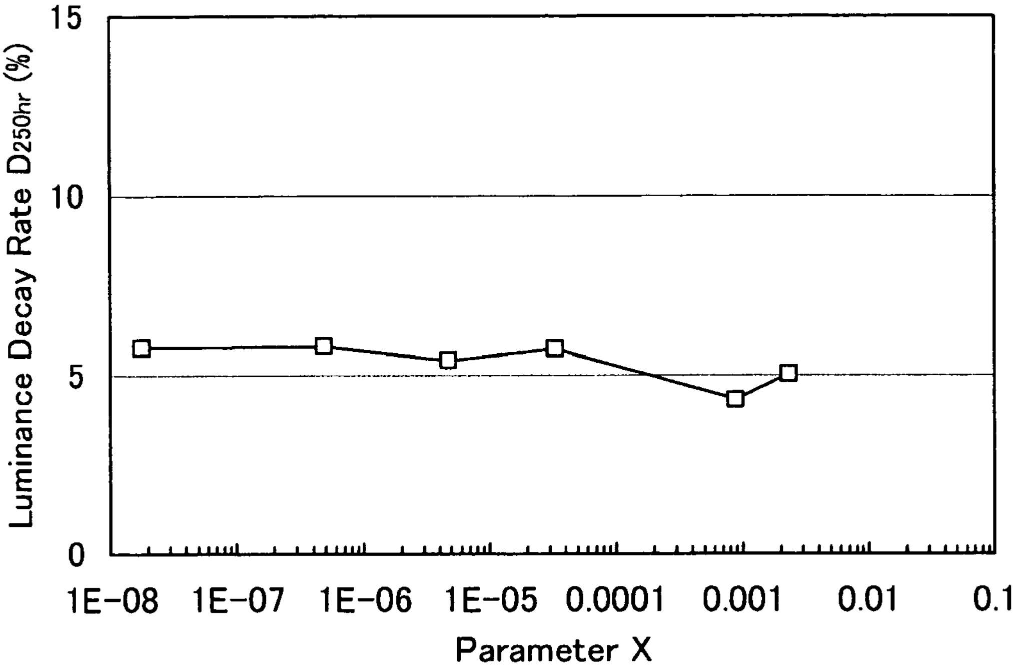
15
10
5
0
Luminance Decay Rate D250hr (%)
1E-08
1E-07
1E-06
1E-05
0.0001
0.001
0.01
0.1
Parameter X

FIG. 26

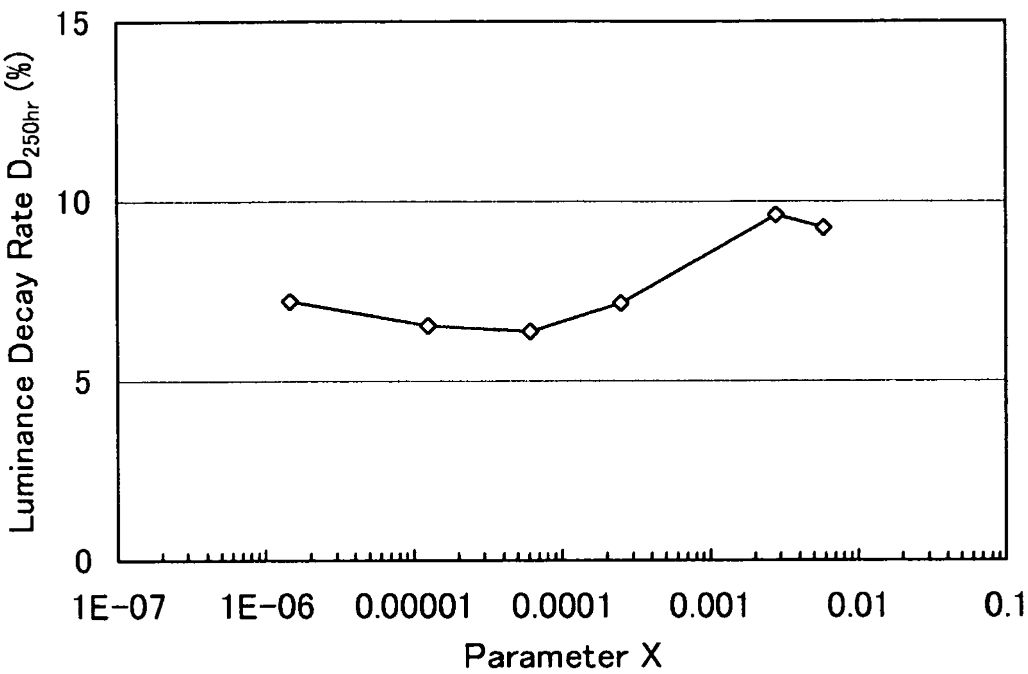
15
10
5
0
Luminance Decay Rate $D_{250hr}$ (%)
1E-07
1E-06
0.00001
0.0001
0.001
0.01
0.1
Parameter X

FIG. 27

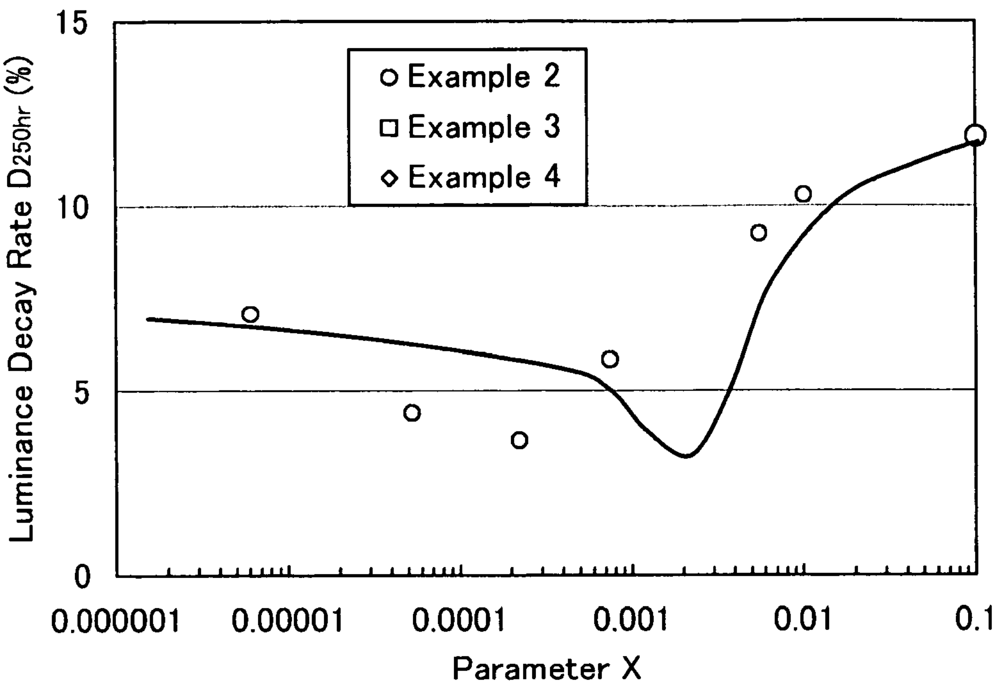
15
10
5
0
Luminance Decay Rate D250hr (%)
Example 2
Example 3
Example 4
0.000001
0.00001
0.0001
0.001
0.01
0.1
Parameter X

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2008032467 A


### Non-patent literature cited in the description


- **T Tsutsui.** *Japanese Journal of Applied Physics,* 1999, vol. 38, L1502-L1504
- **C. R. Goldsmith et al.** *J. Am. Chem. Soc.,* 2002, vol. 124 (1), 83-96
- **T. Ohnishi ; T. Koyama.** High Molecular EL Material. Kyoritsu Shuppan, 64-67